# EUROPEAN PATENT APPLICATION

(11) **EP 4 841 674 A1**
(43) Date of publication of application: **18.11.2026**
(21) Application number: 24921447.9
(22) Date of filing: 18.09.2024
(51) Int. Cl.: H01L 23/48

(54) **CHIP AND MANUFACTURING METHOD THEREFOR, AND ELECTRONIC DEVICE**

(30) Priority: 02.02.2024 CN 202410157375
(71) Applicant: Huawei Technologies Co., Ltd., Shenzhen, Guangdong 518129 (CN)
(72) Inventor: WANG, Xiao, Shenzhen, Guangdong 518129 (CN); XU, Yannan, Shenzhen, Guangdong 518129 (CN); LV, Hangbing, Shenzhen, Guangdong 518129 (CN); XU, Shengqiang, Shenzhen, Guangdong 518129 (CN); WANG, Chao, Shenzhen, Guangdong 518129 (CN); GU, Junxing, Shenzhen, Guangdong 518129 (CN)
(74) Representative: Huawei European IPR
(86) International application number: PCT/CN2024/119522
(87) International publication number: WO 2025/161422

(57) **Abstract**

Embodiments of this application provide a chip and a manufacturing method therefor, and an electronic device, and relate to the field of semiconductor technologies, to improve performance of a component in the electronic device while meeting a miniaturization requirement for the component. The chip includes a plurality of array structures, and a first isolation barrier wall in the array structure is located between a first transistor column and a second transistor column. Both the first transistor column and the second transistor column include a plurality of vertical channels, a gate dielectric layer, and a first signal line. The plurality of vertical channels are spaced from each other on a side wall of the first isolation barrier wall. The gate dielectric layer and the first signal line wrap the vertical channel on three sides, and the gate dielectric layer and the first signal line continuously cover the plurality of vertical channels, and a part of the first isolation barrier wall between the plurality of vertical channels. The gate dielectric layer, the first signal line, and the vertical channel wrapped by the gate dielectric layer and the first signal line form a vertical transistor. The vertical transistor is provided, on only one side, with a first signal line that is used as a gate, to improve device miniaturization.

## Description

This application claims priority to Chinese Patent Application No. 202410157375.2, filed with the China National Intellectual Property Administration on February 2, 2024 and entitled "CHIP AND MANUFACTURING METHOD THEREFOR, AND ELECTRONIC DEVICE", which is incorporated herein by reference in its entirety.

### TECHNICAL FIELD

This application relates to the field of semiconductor technologies, and in particular, to a chip and a manufacturing method therefor, and an electronic device.

### BACKGROUND

With continuous development of semiconductor processes, components in an electronic device, such as a storage chip, need to be continuously miniaturized, so as to meet user requirements for high performance, such as a large capacity and high bandwidth storage, within a limited layout space of the electronic device. However, performance and storage density of the storage chip gradually become important factors that limit performance of the electronic device. For example, as storage density continuously increases, the size of a memory cell in the storage chip is reduced. This affects performance of a component in the storage chip, for example, a transistor, reducing product reliability.

### SUMMARY

This application provides a chip and a manufacturing method therefor, and an electronic device, to improve performance of a component in the electronic device while meeting a miniaturization requirement for the component.

To achieve the foregoing objective, this application uses the following technical solutions.

According to an aspect of this application, a chip is provided. The chip includes a substrate and a plurality of array structures. The plurality of array structures are disposed on the substrate, and the plurality of array structures are spaced from each other in a first direction. The array structure includes a first isolation barrier wall, a first transistor column, and a second transistor column. The first isolation barrier wall is located between the first transistor column and the second transistor column. Both the first transistor column and the second transistor column include a plurality of vertical channels, a gate dielectric layer, and a first signal line. The plurality of vertical channels are spaced from each other on a side wall of the first isolation barrier wall in a second direction, the vertical channel is vertically disposed on the substrate, the first direction intersects with the second direction, and both the first direction and the second direction are parallel to the substrate. The gate dielectric layer is located on a side of the vertical channel that faces away from the isolation barrier wall, the gate dielectric layer wraps the vertical channel on three sides, and the gate dielectric layer continuously covers the plurality of vertical channels, and a part of the first isolation barrier wall between the plurality of vertical channels. The first signal line is located on a side of the gate dielectric layer that faces away from the first isolation barrier wall, the first signal line wraps the vertical channel on three sides, and the first signal line continuously covers the plurality of vertical channels, and the part of the first isolation barrier wall between the plurality of vertical channels.

It can be learned from the foregoing descriptions that, the first isolation barrier wall is located between the first transistor column and the second transistor column, and in either of the first transistor column and the second transistor column, the first signal line is disposed on the side of the gate dielectric layer or the vertical channel that faces away from the first isolation barrier wall. Therefore, the vertical channel and a part of the first signal line that wraps the vertical channel may form a vertical transistor, and the part of the first signal line that wraps the vertical channel may be a gate of the vertical transistor. Because a side of the vertical channel of the vertical transistor that faces the first isolation barrier wall is located on the side wall of the first isolation barrier wall, no gate is disposed on the side of the vertical channel that faces the first isolation barrier wall. In this way, in the first direction, the gate is disposed on only one side of the vertical transistor, so that the chip has miniaturization in the first direction. In addition, the vertical channel of the vertical transistor is located on the side wall of the first isolation barrier wall, and the first isolation barrier wall may support the vertical channel. Therefore, processing difficulty in reducing a thickness of the vertical channel in the first direction can be reduced, thereby improving miniaturization.

In addition, the first signal line wraps the vertical channel on the three sides, to cover the first signal line on three sides in a three-dimensional manner, so that electric field lines of the vertical transistor are more concentrated. This helps improve a gate control capability and an on-state current of the vertical transistor and improve performance of the vertical transistor, thereby improving performance of a component in an electronic device while meeting a miniaturization requirement for the component. In addition, both the gate dielectric layer and the first signal line may continuously cover the plurality of vertical channels, and the part of the first isolation barrier wall between the plurality of vertical channels. Therefore, in a direction (that is, the second direction) in which the plurality of vertical channels are arranged, both the gate dielectric layer and the first signal line are continuous structures. In this way, in a manufacturing procedure, the plurality of vertical channels that are spaced from each other may be first formed on two sides of the first isolation barrier wall, and then the gate dielectric layer and the first signal line are sequentially formed on a side of a plurality of vertical channels in any row that faces away from the first isolation barrier wall.

In an optional implementation, the vertical channel includes a first part and a second part. The first part is disposed in a direction perpendicular to the substrate. The second part is connected to an end of the first part that faces the substrate, and the second part is disposed in the first direction. The chip further includes a second signal line, where the second signal line is disposed between the array structure and the substrate, the second signal line extends in the first direction, and the second signal line is in contact with the second part. In this way, because the second part is electrically connected to the second signal line, and the second part is disposed in the first direction, a contact area between the entire vertical channel and the second signal line can be increased due to the second part, thereby reducing a contact resistance.

In an optional implementation, second parts of two adjacent vertical channels in different array structures are connected, so that the two connected vertical channels form a U-shaped structure. A part of a U-shaped semiconductor structure is disposed in the first direction, and is electrically connected to the second signal line. Therefore, the contact area between the entire vertical channel and the second signal line can be increased, thereby reducing the contact resistance.

In an optional implementation, the chip includes a plurality of second signal lines. The chip further includes a third isolation barrier wall, and the third isolation barrier wall is disposed between two adjacent second signal lines, so that the adjacent second signal lines can be isolated. In addition, the third isolation barrier wall and the first isolation barrier wall are made of different materials. In this way, in a procedure of performing wet etching on the third isolation barrier wall, a structure of the first isolation barrier wall is not affected.

In an optional implementation, in different array structures, two adjacent first signal lines are connected to form an integrated conductive structural part, and the integrated conductive structural part is filled between two adjacent rows of vertical channels. The integrated conductive structural part and two oppositely disposed vertical channels surrounded by three sides of the integrated conductive structural part may form a dual-channel vertical transistor. In comparison with a single-channel vertical transistor, an on-state current of the dual-channel vertical transistor may be doubled.

In an optional implementation, the chip further includes a second isolation barrier wall. The second isolation barrier wall is disposed between two adjacent array structures, and is located on a side of the integrated conductive structural part that faces away from the substrate. The second isolation barrier wall is configured to isolate a part of the vertical channel that is in the two adjacent array structures and that is not covered by the integrated conductive structural part.

In an optional implementation, the chip further includes a second isolation barrier wall. The second isolation barrier wall is disposed between two adjacent array structures. Two adjacent first signal lines in different array structures are isolated on two sides of the second isolation barrier wall, and two adjacent vertical channels in the different array structures are isolated on the two sides of the second isolation barrier wall. The second isolation barrier wall may isolate the two adjacent first signal lines in the different array structures. In addition, the second isolation barrier wall may further isolate the two adjacent vertical channels in the different array structures. A surface of a side of the first signal line that faces away from the first isolation barrier wall is flush with a surface of a side of the second part that faces away from the first isolation barrier wall and a surface of a side of the gate dielectric layer that faces away from the first isolation barrier wall. In this way, the L-shaped vertical channel, the gate dielectric layer, and the first signal line may be formed simultaneously through a photolithography process.

In an optional implementation, the first signal line covers a surface of the first part that faces away from the first isolation barrier wall, and surfaces of the first part and the second part that are perpendicular to the first isolation barrier wall and the substrate. In this case, a part of the first signal line that covers the second part is similar to a horseshoe shape, so that a coverage area of the first signal line can be increased, thereby reducing a resistance of the first signal line.

In an optional implementation, the chip further includes a second isolation barrier wall, where the second isolation barrier wall is disposed between two adjacent array structures, and two adjacent first signal lines in different array structures are isolated on two sides of the second isolation barrier wall. Technical effects of the second isolation barrier wall are the same as that described above, and details are not described herein again. The first signal line covers a part of the first isolation barrier wall and has a first trench on a side facing away from the first isolation barrier wall, and a part of the second isolation barrier wall is located in the first trench. A top view structure of the second isolation barrier wall located between the two adjacent array structures may be similar to a shape of " 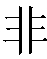 " (a Chinese character).

In an optional implementation, the first transistor column and the second transistor column are symmetrically disposed with respect to the first isolation barrier wall. In this way, a structure of the chip may have a specific regularity, and in a procedure of preparing the chip through a patterning process, preparing a patterned structure having the regularity can simplify a manufacturing process.

In an optional implementation, each of the first transistor column and the second transistor column further includes a first electrode and a second electrode. The first electrode is disposed on a side of the vertical channel that faces the substrate. The second electrode is disposed on a side of the vertical channel that faces away from the substrate. In this case, a voltage may be applied to the first electrode (for example, a source) and the second electrode (for example, a drain), so that a conduction current flows through the vertical channel. In this case, the vertical transistor in the transistor column may be in an on state. Alternatively, when no conduction current flows through the vertical channel, the vertical transistor may be in an off state.

In an optional implementation, the chip further includes a capacitor array, where the capacitor array is disposed on a side of the array structure that faces away from the substrate, where the capacitor array is electrically connected to at least one of the first transistor column or the second transistor column, to form a memory array. The chip having the memory array may be a storage chip.

In an optional implementation, the chip further includes a controller, where the controller is electrically connected to the memory array, and the controller is configured to control read/write of the memory array, to implement access to the memory array.

According to another aspect of this application, a chip is provided. The chip includes a substrate and a plurality of array structures. The plurality of array structures are disposed on the substrate, and the plurality of array structures are spaced from each other in a first direction. The array structure includes a first isolation barrier wall, a first transistor column, and a second transistor column. The first isolation barrier wall is located between the first transistor column and the second transistor column. Both the first transistor column and the second transistor column include a plurality of vertical channels, a gate dielectric layer, and a first signal line. The plurality of vertical channels are spaced from each other on a side wall of the first isolation barrier wall in a second direction, the vertical channel is vertically disposed on the substrate, the first direction intersects with the second direction, and both the first direction and the second direction are parallel to the substrate. The gate dielectric layer is located on a side of the vertical channel that faces away from the isolation barrier wall, the gate dielectric layer wraps the vertical channel on three sides, and the gate dielectric layer continuously covers the plurality of vertical channels, and a part of the first isolation barrier wall between the plurality of vertical channels. The first signal line is located on a side of the gate dielectric layer that faces away from the first isolation barrier wall, the first signal line wraps the vertical channel on three sides, and the first signal line continuously covers the plurality of vertical channels, and the part of the first isolation barrier wall between the plurality of vertical channels. The first signal line may be used as gates of a plurality of transistors in the first transistor column or the second transistor column. The chip has same technical effects as the chip provided in the foregoing embodiment, and details are not described herein again.

According to another aspect of this application, an electronic device is provided, including a circuit board and any one of the foregoing chips. The circuit board is electrically connected to the chip. The electronic device has the same technical effects as the chip provided in the foregoing embodiment, and details are not described herein again.

According to another aspect of this application, a manufacturing method for a chip is provided, including: forming, on a substrate, a plurality of first isolation barrier walls that are spaced from each other in a first direction; and forming a transistor column on each of two side walls of the first isolation barrier wall. Forming the transistor column on each of the two side walls of the first isolation barrier wall includes: forming, on the side wall, a plurality of vertical channels that are spaced from each other in a second direction, where the vertical channel is perpendicular to the substrate. The first direction intersects with the second direction, and both the first direction and the second direction are parallel to the substrate. Next, a gate dielectric layer is formed on a side of the plurality of vertical channels that faces away from the isolation barrier wall. The gate dielectric layer wraps the vertical channel on three sides, and the gate dielectric layer continuously covers the plurality of vertical channels, and a part of the first isolation barrier wall between the plurality of vertical channels. Next, a first signal line is formed on a side of the gate dielectric layer that faces away from the first isolation barrier wall. The first signal line wraps the vertical channel on three sides, and the first signal line continuously covers the plurality of vertical channels, and the part of the first isolation barrier wall between the plurality of vertical channels. In this way, the first signal line formed on the gate dielectric layer may be conformal with the gate dielectric layer.

In an optional implementation, forming, on the substrate, the plurality of first isolation barrier walls that are spaced from each other in the first direction includes forming a semiconductor material layer on the substrate. Next, a plurality of second trenches that extend in the first direction are formed on the semiconductor material layer, and a third isolation barrier wall is formed in the second trench, where the third isolation barrier wall and the first isolation barrier wall are made of different materials. Next, a first mask structure is formed on the semiconductor material layer. Next, the semiconductor material layer and the third isolation barrier wall that are exposed by the first mask structure are removed, to form a plurality of third trenches that are spaced from each other in the first direction. Next, the first isolation barrier wall is formed in the third trench. A size and a location of the first isolation barrier wall formed through a photolithography process and a deposition process, and a spacing between the plurality of first isolation barrier walls have high precision.

In an optional implementation, after the first mask structure is formed, forming, on the side wall, the plurality of vertical channels that are spaced from each other in the second direction includes: removing the first mask structure, forming a second mask structure on the side wall of the first isolation barrier wall, and removing the semiconductor material layer and the third isolation barrier wall that are exposed by the second mask structure, to form the vertical channel. The vertical channel and the first signal line that covers the vertical channel may form the vertical transistor.

In an optional implementation, after the first mask structure is formed, forming, on the side wall, the plurality of vertical channels that are spaced from each other in the second direction includes: removing the first mask structure, forming a second mask structure on the side wall of the first isolation barrier wall, and removing a part of the semiconductor material layer and the third isolation barrier wall that are exposed by the second mask structure, to form a plurality of U-shaped vertical channels. Technical effects of the U-shaped vertical channel are the same as that described above, and details are not described herein again.

In an optional implementation, after the first mask structure is formed, forming, on the side wall, the plurality of vertical channels that are spaced from each other in the second direction, and forming the gate dielectric layer and the first signal line include: removing the first mask structure, forming a second mask structure on the side wall of the first isolation barrier wall, and removing a part of the semiconductor material layer and the third isolation barrier wall that are exposed by the second mask structure, to form a plurality of U-shaped semiconductor structures. Next, a gate dielectric material layer and a second metal material layer are sequentially formed in the U-shaped semiconductor structure. Both the gate dielectric material layer and the second metal material layer wrap the plurality of U-shaped semiconductor structures on three sides, and both the gate dielectric material layer and the second metal material layer continuously cover the U-shaped semiconductor structure, and a part of the first isolation barrier wall between the plurality of U-shaped semiconductor structures. Next, a part of the bottom of the U-shaped semiconductor structure is removed, and a part of the gate dielectric material layer and a part of the second metal material layer that cover the bottom of the U-shaped semiconductor structure is removed, to form the L-shaped vertical channel, the gate dielectric layer, and the first signal line. Technical effects of the L-shaped vertical channel are the same as that described above, and details are not described herein again.

### BRIEF DESCRIPTION OF DRAWINGS

FIG. 1 is a diagram of a structure of an electronic device according to an embodiment of this application;
FIG. 2 is a diagram of a structure of a chip used in an electronic device according to an embodiment of this application;
FIG. 3 is a top view taken along a direction A in FIG. 2;
FIG. 4 is another top view taken along a direction A in FIG. 2;
FIG. 5 is a diagram of a structure of two vertical transistors that are symmetrically disposed in 2;
FIG. 6 is a cross-sectional view obtained by performing sectioning along a dashed line O1-O2 in FIG. 5;
FIG. 7 is a diagram of a structure of another chip used in an electronic device according to an embodiment of this application;
FIG. 8 is a diagram of a structure of another chip used in an electronic device according to an embodiment of this application;
FIG. 9 is a diagram of a structure of another chip used in an electronic device according to an embodiment of this application;
FIG. 10 is a cross-sectional view obtained by performing sectioning along a dashed line O3-O4 in FIG. 7;
FIG. 11 is a diagram of a structure of a memory array shown in FIG. 9;
FIG. 12 is a diagram of a structure of another chip used in an electronic device according to an embodiment of this application;
FIG. 13 is a flowchart of a manufacturing method for a chip according to an embodiment of this application;
FIG. 14 is a diagram of a structure of a part in a chip manufacturing procedure according to an embodiment of this application;
FIG. 15 is a diagram of a structure of another part in a chip manufacturing procedure according to an embodiment of this application;
FIG. 16A is a diagram of a structure of another part in a chip manufacturing procedure according to an embodiment of this application;
FIG. 16B is a top view taken along a direction B1 in FIG. 16A;
FIG. 17A is a diagram of a structure of another part in a chip manufacturing procedure according to an embodiment of this application;
FIG. 17B is a top view taken along a direction B2 in FIG. 17A;
FIG. 18A is a diagram of a structure of another part in a chip manufacturing procedure according to an embodiment of this application;
FIG. 18B is a top view taken along a direction B3 in FIG. 18A;
FIG. 19A is a diagram of a structure of another part in a chip manufacturing procedure according to an embodiment of this application;
FIG. 19B is a top view taken along a direction B4 in FIG. 19A;
FIG. 20A is a diagram of a structure of another part in a chip manufacturing procedure according to an embodiment of this application;
FIG. 20B is a top view taken along a direction B5 in FIG. 20A;
FIG. 21A is a diagram of a structure of another part in a chip manufacturing procedure according to an embodiment of this application;
FIG. 21B is a top view taken along a direction B6 in FIG. 21A;
FIG. 22A is a diagram of a structure of another part in a chip manufacturing procedure according to an embodiment of this application;
FIG. 22B is a top view taken along a direction B7 in FIG. 22A;
FIG. 23 is a diagram of a structure of another part in a chip manufacturing procedure according to an embodiment of this application;
FIG. 24A is a diagram of a structure of another part in a chip manufacturing procedure according to an embodiment of this application;
FIG. 24B is a top view taken along a direction B8 in FIG. 24A;
FIG. 25A is a diagram of a structure of another part in a chip manufacturing procedure according to an embodiment of this application;
FIG. 25B is a top view taken along a direction B9 in FIG. 25A;
FIG. 26A is a diagram of a structure of another part in a chip manufacturing procedure according to an embodiment of this application;
FIG. 26B is a cross-sectional view obtained by performing sectioning along a dashed line O5-O6 in FIG. 26A;
FIG. 27 is a diagram of a structure of another part in a chip manufacturing procedure according to an embodiment of this application;
FIG. 28A is a diagram of a structure of another chip used in an electronic device according to an embodiment of this application;
FIG. 28B is a top view taken along a direction C1 in FIG. 28A;
FIG. 29A is a diagram of a structure of another chip used in an electronic device according to an embodiment of this application;
FIG. 29B is a cross-sectional view obtained by performing sectioning along a dashed line O7-O8 in FIG. 29A;
FIG. 29C is a top view taken along a direction C2 in FIG. 29A;
FIG. 30A is a diagram of a structure of another chip used in an electronic device according to an embodiment of this application;
FIG. 30B is a side view taken along a direction C3 in FIG. 30A;
FIG. 30C is a top view taken along a direction C4 in FIG. 30A;
FIG. 30D is a cross-sectional view obtained by performing sectioning along a dashed line P1-P2 in FIG. 30A;
FIG. 31 is a diagram of a structure of a vertical channel in a chip according to an embodiment of this application;
FIG. 32 is a diagram of a structure of another chip used in an electronic device according to an embodiment of this application;
FIG. 33 is a diagram of a partial structure in a structure of a chip used in an electronic device according to an embodiment of this application;
FIG. 34A is a diagram of a structure of another chip used in an electronic device according to an embodiment of this application;
FIG. 34B is a side view taken along a direction D2 in FIG. 34A;
FIG. 34C is a cross-sectional view obtained by performing sectioning along a dashed line P3-P4 in FIG. 34A;
FIG. 35 is a diagram of a structure of another part in a chip manufacturing procedure according to an embodiment of this application;
FIG. 36 is a diagram of a structure of another chip used in an electronic device according to an embodiment of this application;
FIG. 37A is a diagram of a structure of another chip used in an electronic device according to an embodiment of this application;
FIG. 37B is a cross-sectional view obtained by performing sectioning along a dashed line P5-P6 in FIG. 37A; and
FIG. 37C is a side view taken along a direction C3 in FIG. 37A.

### Reference numerals:

01: electronic device; 101: bus; 102: SoC; 103: second RAM; 104: communication chip; 105: power management chip; 112: AP; 122: GPU; 132: first RAM; 20: chip; 21: array structure; 211: first isolation barrier wall; 221: first transistor column; 222: second transistor column; 200: substrate; 2101: vertical channel; 2102: gate dielectric layer; 2103: first signal line; T1: first vertical transistor; T2: second vertical transistor; 504: fourth trench; a1: first surface; a2: second surface; a3: third surface; a4: fourth surface; 30: memory array; 31: controller; 300: memory cell; 311: decoder; 312: driver; 313: timing controller; 314: cache; 315: input/output drive; 41: bottom electrode; 42: dielectric layer; 43: top electrode; 2104: second signal line; 51: first metal material layer; 52: semiconductor material layer; 213: third isolation barrier wall; 53: first mask structure; 503: third trench; 54: second mask structure; 55: second metal material; 212: second isolation barrier wall; 501: first trench; 60: metal contact electrode; 400: integrated conductive structural part; 21011: first part; 21012: second part; 520: U-shaped semiconductor structure; and 56: third mask structure.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

Terms such as "first" and "second" below are merely for convenience of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In this application, unless otherwise expressly specified and limited, the term "connection" should be understood in a broad sense. For example, "connection" may be a fixed mechanical connection, or may be a detachable mechanical connection or an integration. Alternatively, "connection" may be a direct connection, or may be an indirect connection via an intermediate medium.

In addition, unless otherwise expressly specified and limited, the term "electrical connection" should be understood in a broad sense. For example, "electrical connection" may be a direct electrical connection, for example, two components are physically in contact and electrically connected; or may be understood as that in a line structure, different components are electrically connected through a physical line that can transmit an electrical signal, such as a printed circuit board (printed circuit board, PCB) copper foil or a conducting wire, to transmit an electrical signal. Alternatively, "electrical connection" may be an indirect electrical connection between two components via an intermediate medium. Alternatively, "electrical connection" may be an electrical connection between two components in a separated/non-contact manner. For example, two components are electrically connected in a capacitive coupling manner, to transmit an electrical signal.

In embodiments of this application, "perpendicular" and "parallel" are described to respectively represent being roughly perpendicular and being roughly parallel within an allowed error range. The error range may be a range in which a deviation angle is less than or equal to 5°, 8°, or 10° relative to being absolutely perpendicular and being absolutely parallel. This is not specifically limited herein.

In embodiments of this application, orientation terms such as ''upper'', ''lower'', "left", and "right" may include but are not limited to definitions based on illustrated orientations in which components in the accompanying drawings are placed. It should be understood that, these directional terms may be relative concepts used for relative description and clarification, and may change accordingly depending on a change in the orientations in which the components are placed in the accompanying drawings.

In the accompanying drawings of embodiments of this application, an assembly is represented by a guide line with an arrow, a component is represented by only a guide line, and an opening like an opening or a hole is represented a guide line with a wavy line at an end part.

An embodiment of this application provides an electronic device. The electronic device may be applied to various communication systems or communication protocols, for example, a Bluetooth (Bluetooth, BT) communication technology, a global positioning system (global positioning system, GPS) communication technology, a global system of mobile communication (global system of mobile communication, GSM) communication technology, a wireless fidelity (wireless fidelity, Wi-Fi) communication technology, a wideband code division multiple access (wideband code division multiple access wireless, WCDMA) communication technology, long term evolution (long term evolution, LTE), a 5G communication technology, and another future communication technology.

The electronic device in this embodiment of this application may be a mobile phone (mobile phone), a tablet computer (pad), a notebook computer, a smart home, a smart wearable device (for example, a smartwatch, a smart band, smart glasses, or a smart helmet), a virtual reality (virtual reality, VR) electronic device, an augmented reality (augmented reality, AR) electronic device, or the like. Alternatively, the electronic device may be a handheld device that has a wireless communication function, a compute device or another processing device connected to a wireless modem, a vehicle-mounted device, an electronic device in a 5G network, an electronic device in a future evolved public land mobile network (public land mobile network, PLMN), or the like. This is not limited in embodiments of this application.

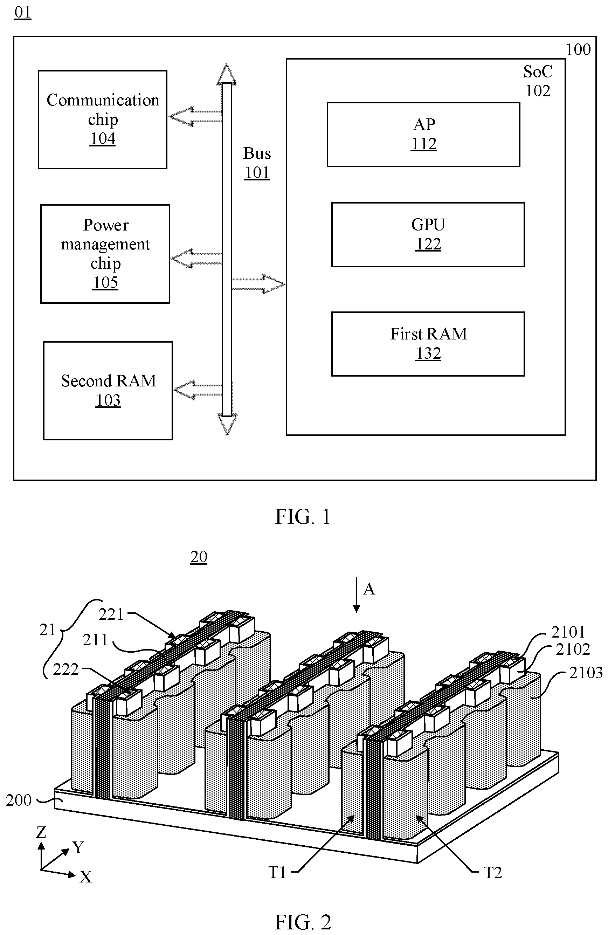

For example, as shown in FIG. 1, the electronic device 01 may include a circuit board (for example, the foregoing PCB) 100, a bus 101 disposed on the PCB 100 and electrically connected to the PCB 100, and a processor connected to the bus 101, for example, a system on a chip (system on a chip, SoC) 102, a central processing unit (central processing unit, CPU for short), or a microcontroller unit (microcontroller unit, MCU). The SoC 102 may be configured to process data, for example, process data of an application, process image data, and cache temporary data.

In an implementation, the SoC 102 may include an application processor (application processor, AP) 112 configured to process an application, a graphics processing unit (graphics processing unit, GPU) 122 configured to process image data, and a first RAM 132 configured to cache high-speed data. The first RAM 132 may be a static random access memory (static random access memory, SRAM), an embedded flash (embedded flash, eflash), or the like. The SoC or the CPU may be referred to as a logic chip. For example, the first RAM 132 may be integrated into a chip with the AP 112 and the GPU 122, or the first RAM 132 may be independently disposed in a storage chip.

In addition, still as shown in FIG. 1, the electronic device 01 may further include a storage chip, for example, a second RAM 103, connected to the SoC 102 through the bus 101. The second RAM 103 may be a dynamic random access memory (dynamic random access memory, DRAM). The second RAM 103 may be configured to store volatile data, for example, temporary data generated by the SoC 102. A memory capacity of the second RAM 103 may be usually greater than that of the first RAM 132, but a read speed of the second RAM 103 is usually slower than that of the first RAM 132.

In addition, the electronic device 01 may further include a communication chip 104 and a power management chip 105 that are connected to the SoC 102 through the bus 101. The communication chip 104 may be configured to process a protocol stack, or perform processing such as amplification and filtering on an analog radio frequency signal, or implement the foregoing functions at the same time. The power management chip 105 may be configured to supply power to another chip. In an implementation, the SoC 102 and the second RAM 103 may be packaged in a packaging structure. For example, 2.5D (dimension) or 3D packaging is used, to obtain a faster inter-chip data transmission rate.

The foregoing describes the chip provided in embodiments of this application by using the logic chip, the storage chip, the communication chip, or the like as an example, and does not constitute a limitation on a chip type. Other types of chips are not described herein. In addition, as shown in FIG. 2, a chip 20 provided in this embodiment of this application may include a substrate 200 and a plurality of array structures 21. In FIG. 2, three array structures 21 are used as an example for description. A quantity of array structures 21 is not limited in this application. The plurality of array structures 21 may be disposed on the substrate 200, and the plurality of array structures 21 are spaced from each other in a first direction X.

The "substrate" is a structure in which another film layer may be prepared. The substrate may be patterned or unpatterned, and the film layer manufactured on the substrate may also be patterned or unpatterned. Further, the substrate may include a semiconductor material, for example, silicon, germanium, gallium arsenide, or indium phosphide. Alternatively, the substrate may further include a non-conductive material, for example, glass, resin, or sapphire. This is not limited in this application.

To describe a structure of the chip 20 by using an example below, an XYZ coordinate system is established in the accompanying drawings. The first direction X is a direction in which the plurality of array structures 21 are arranged, and a second direction Y is disposed in a cross manner with (for example, may be perpendicular to) the first direction X. Both the first direction X and the second direction Y are parallel to a bearing surface (a surface used to bear the array structure 21) of the substrate 200. Therefore, a plane formed by the first direction X and the second direction Y may be parallel to the bearing surface of the substrate 200. In addition, a third direction Z is a direction perpendicular to the substrate 200.

On this basis, still as shown in FIG. 2, each array structure 21 may include a first isolation barrier wall 211, a first transistor column 221, and a second transistor column 222. The first isolation barrier wall 211 is located between the first transistor column 221 and the second transistor column 222. Both the first transistor column 221 and the second transistor column 222 may include a plurality of vertical channels (channels) 2101, a gate dielectric layer 2102, and a first signal line 2103. The first isolation barrier wall 211 may also be referred to as a shallow trench isolation (shallow trench isolation, STI) structure.

The plurality of vertical channels 2101 may be spaced from each other on a side wall of the first isolation barrier wall 211 in the second direction Y. In addition, the vertical channel 2101 is vertically disposed on the substrate 200. In this case, an extension direction of the vertical channel 2101 may be the third direction Z that is perpendicular to the bearing surface of the substrate 200. The vertical channel 2101 may include a semiconductor material. The gate dielectric layer 2102 may also be referred to as a gate oxide (gate oxide, Gate-OX) dielectric layer.

For example, a length of the vertical channel 2101 in the third direction Z may be 30 nm to 500 nm, a width of the vertical channel 2101 in the second direction Y may be 10 nm to 100 nm, and a thickness of the vertical channel 2101 in the first direction X may be 5 nm to 50 nm. In this case, the vertical channel 2101 may be a nanowire (nanowire, NW). In addition, a material of the vertical channel 2101 may include but is not limited to: monocrystalline silicon, monocrystalline germanium, polycrystalline silicon, polycrystalline germanium, an oxide semiconductor, for example, indium gallium zinc oxide (indium gallium zinc oxide, IGZO) or indium tungsten oxide (IWO), an organic semiconductor (for example, pentacene or P3HT), a two-dimensional material semiconductor, for example, molybdenum disulfide (MoS₂) or tungsten selenide (WSe₂), or a one-dimensional semiconductor, for example, a carbon nanotube (CNT).

In addition, the gate dielectric layer 2102 may wrap the vertical channel 2101 on three sides, and the gate dielectric layer 2102 continuously covers the plurality of vertical channels 2101, and a part of the first isolation barrier wall 211 between the plurality of vertical channels 2101. For example, the gate dielectric layer 2102 may include a dielectric material, for example, silicon oxide (for example, SiO₂), silicon nitride (SiNₓ), silicon oxynitride, or a high dielectric constant k material, for example, hafnium dioxide (HfO₂) or zirconium dioxide (ZrO₂). In addition, the first signal line 2103 is located on a side of the gate dielectric layer 2102 that faces away from the first isolation barrier wall 211. The first signal line 2103 may wrap the vertical channel 2101 on three sides, and the first signal line 2103 continuously covers the plurality of vertical channels 2101, and the part of the first isolation barrier wall 211 between the plurality of vertical channels 2101. The first signal line 2103 may include a metal material.

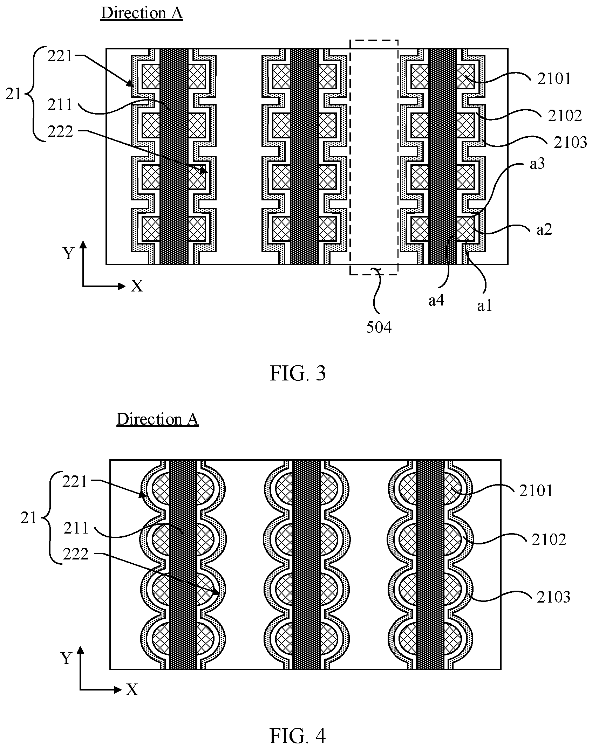

The following uses an example to describe a manner in which the gate dielectric layer 2102 and the first signal line 2103 wrap the vertical channel 2101 on the three sides. For example, as shown in FIG. 3 (a top view taken along a direction A in FIG. 2), a shape of a cross section (parallel to an XY plane) of the vertical channel 2101 may be a rectangle. In this case, that the gate dielectric layer 2102 and the first signal line 2103 wrap the vertical channel 2101 on the three sides means that, in the second direction Y, the gate dielectric layer 2102 and the first signal line 2103 may wrap a first surface a1, a second surface a2, and a third surface a3 that are sequentially connected in the vertical channel 2101. The first surface a1 and the third surface a3 are disposed opposite to each other, and are both disposed perpendicular to the first isolation barrier wall 211. The second surface a2 is disposed opposite to a fourth surface a4 of the vertical channel 2101 that is in contact with the first isolation barrier wall 211, and the second surface a2 may be parallel to the side wall of the first isolation barrier wall 211.

The foregoing is described by using an example in which the cross section of the vertical channel 2101 is a rectangle or a semicircle. For another example, the cross section of the vertical channel 2101 may alternatively be a triangle, a trapezoid, a polygon with more than four sides, or the like. Details are not described herein in this application. As long as the gate dielectric layer 2102 and the first signal line 2103 can wrap, in the second direction Y, a plurality of sequentially connected surfaces of the vertical channel 2101, such a case falls into the protection scope of the gate dielectric layer 2102 and the first signal line 2103 wrapping the vertical channel 2101 on the three sides.

Alternatively, for another example, as shown in FIG. 4 (a top view taken along the direction A in FIG. 2), the shape of the cross section of the vertical channel 2101 may be a semicircle (or a semi-ellipse). In this case, that the gate dielectric layer 2102 and the first signal line 2103 wrap the vertical channel 2101 on the three sides means that, in the second direction Y, the gate dielectric layer 2102 and the first signal line 2103 may wrap an arc surface of the vertical channel 2101.

In addition, the gate dielectric layer 2102 and the first signal line 2103 continuously cover the plurality of vertical channels 2101, and the part of the first isolation barrier wall 211 between the plurality of vertical channels 2101 means that, in the Y direction in FIG. 2, the gate dielectric layer 2102 and the first signal line 2103 are continuous film layers, to be specific, the gate dielectric layer 2102 is connected to a part of the first signal line 2103 that covers the vertical channel 2101, and a part of the gate dielectric layer 2102 and the first signal line 2103 that covers a part of the first isolation barrier wall 211 between two adjacent vertical channels 2101.

On this basis, still as shown in FIG. 2, in the first transistor column 221, a part of the gate dielectric layer 2102 and a part of the first signal line 2103 that wrap the vertical channel 2101 on the three sides and one vertical channel 2101 may form one first vertical transistor T1. Therefore, the first transistor column 221 may include a plurality of first vertical transistors T1 that are located on one side of the first isolation barrier wall 211 and that are spaced from each other in the second direction Y. Similarly, in the second transistor column 222 in FIG. 2, a part of the gate dielectric layer 2102 and a part of the first signal line 2103 that wrap the vertical channel 2101 on the three sides and one vertical channel 2101 may form one second vertical transistor T2. Therefore, the second transistor column 222 may include a plurality of second vertical transistors T2 that are located on the other side of the first isolation barrier wall 211 and that are spaced from each other in the second direction Y. The first vertical transistor T1 and the second vertical transistor T2 are respectively disposed on two sides of the first isolation barrier wall 211. The first vertical transistor T1 and the second vertical transistor T2 may be field effect transistors (field effect transistor, FET). In addition, it can be learned from the foregoing descriptions that the vertical channel 2101 is the nanowire. Therefore, the first vertical transistor T1 and the second vertical transistor T2 may also be referred to as vertical nanowire transistors (vertical nanowire transistor, VNWFET).

In some other embodiments of this application, still as shown in FIG. 2, a chip 20 is provided. As described above, the chip 20 may include a substrate 200 and a plurality of array structures 21 that are disposed on the substrate 200. Each array structure 21 includes a first isolation barrier wall 211, a first transistor column 221, and a second transistor column 222. Both the first transistor column 221 and the second transistor column 222 may include a plurality of vertical channels 2101, a gate dielectric layer 2102, and a first signal line 2103. A manner of disposing the vertical channel 2101, the gate dielectric layer 2102, and the first signal line 2103 is the same as that described above, and details are not described herein again.

It can be learned from the foregoing descriptions that the first signal line 2103 may wrap the vertical channel 2101 on three sides, and the first signal line 2103 continuously covers the plurality of vertical channels 2101, and a part of the first isolation barrier wall 211 between the plurality of vertical channels 2101. In the first transistor column 221, a part of the gate dielectric layer 2102 and a part of the first signal line 2103 that wrap the vertical channel 2101 on three sides and one vertical channel 2101 may form one first vertical transistor T1. In the second transistor column 222, a part of the gate dielectric layer 2102 and a part of the first signal line 2103 that wrap the vertical channel 2101 on three sides and one vertical channel 2101 may form one second vertical transistor T2.

On this basis, the first signal line 2103 may be used as gates of a plurality of transistors in the first transistor column 221 or the second transistor column 222. For example, the first signal line 2103 in the first transistor column 221 may be used as gates of a plurality of first vertical transistors T1 in the first transistor column 221. Similarly, the first signal line 2103 in the second transistor column 222 may be used as gates of a plurality of second vertical transistors T2 in the second transistor column 222. Specifically, a part of the first signal line 2103 that wraps one vertical channel 2101 on the three sides is a gate of a first vertical transistor T1 or a second vertical transistor T2 having the vertical channel 2101.

In this case, each of the vertical channel 2101 of the first vertical transistor T1 and the vertical channel 2101 of the second vertical transistor T2 is wrapped, on the three sides, by the first signal line 2103 used as the gate. Therefore, in the first vertical transistor T1 and the second vertical transistor T2, the first signal line 2103 used as the gate may be referred to as a tri-gate (tri-gate) structure, and the vertical channel 2101 may also be referred to as a gate all around (gate all around, GAA) channel.

In some embodiments of this application, the first transistor column 221 and the second transistor column 222 may be symmetrically disposed with respect to the first isolation barrier wall 211. In this case, the first vertical transistor T1 in the first transistor column 221 and the second vertical transistor T2 in the second transistor column 222 may be symmetrically disposed with respect to the first isolation barrier wall 211. In this way, a structure of the chip 20 may have a specific regularity, and in a procedure of preparing the chip 20 through a patterning process, preparing a patterned structure having the regularity can simplify a manufacturing process.

In this embodiment of this application, the patterning process may include a photolithography process, or include a photolithography process and an etching step, and may further include another process, for example, printing or inkjet, for forming a predetermined image. The photolithography process is a process that includes processes of film forming, exposing, developing, and the like and in which a photoresist, a mask reticle, an exposure machine, and the like are used to form an image. A corresponding patterning process may be selected based on the structure formed in this application.

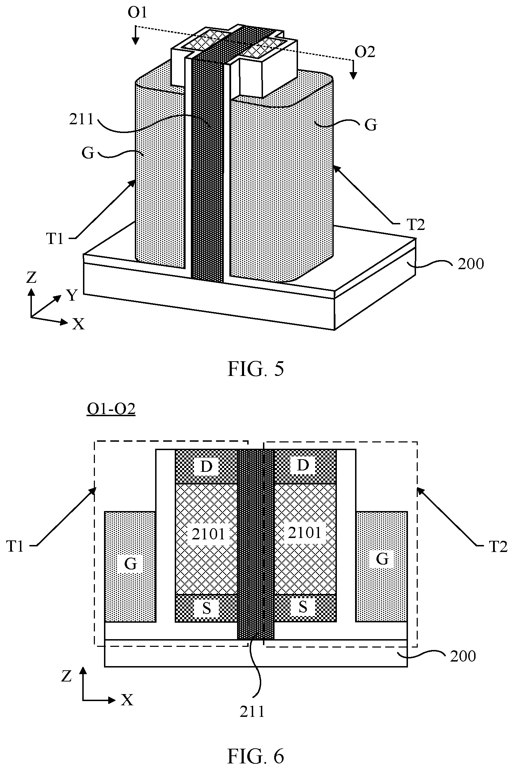

In addition, as shown in FIG. 5, a part of the first signal line 2103 (as shown in FIG. 2) in the first vertical transistor T1 may be used as a gate (gate, G) of the first vertical transistor T1, and a part of the first signal line 2103 (as shown in FIG. 2) in the second vertical transistor T1 may be used as a gate G of the second vertical transistor T2. In addition, either of the first vertical transistor T1 and the second vertical transistor T2 may further include a first electrode, for example, a source (source, S) and a second electrode, for example, a drain (drain, D), shown in FIG. 6 (a cross-sectional view obtained by performing sectioning along a dashed line O1-O2 in FIG. 5). For ease of description, the following uses an example in which the first electrode of the transistor is the source S and the second electrode of the transistor is the drain D for description. In some other embodiments of this application, the first electrode may be the drain D, and the second electrode may be the source S.

On this basis, still as shown in FIG. 6, the first electrode (for example, the source S) may be disposed on a side of the vertical channel 2101 that faces the substrate 200, and the second electrode (for example, the drain D) may be disposed on a side of the vertical channel 2101 that faces away from the substrate 200. In this case, a voltage may be applied to the first electrode (for example, the source S) and the second electrode (for example, the drain D), so that a conduction current (or an on-state current) flows through the vertical channel 2101. In this case, the first vertical transistor T1 and the second vertical transistor T2 may be in an on state (or an on state, an on state for short). Alternatively, when no conduction current flows through the vertical channel 2101, the first vertical transistor T1 and the second vertical transistor T2 may be in an off state.

For example, in the first vertical transistor T1 or the second vertical transistor T2, the first electrode (for example, the source S), the second electrode (for example, the drain D), and the vertical channel 2101 may be connected to form an integrated structure. In a manufacturing procedure, a columnar intrinsic semiconductor (intrinsic semiconductor) structure may be formed on a side wall of the first isolation barrier wall 211, and ion doping is separately performed on two ends of the semiconductor structure, one facing and the other facing away from the substrate 200, to form the first electrode (for example, the source S) and the second electrode (for example, the drain D). In addition, a part that is between the first electrode (for example, the source S) and the second electrode (for example, the drain D) and that is not ion-doped may form the vertical channel 2101.

In conclusion, in the chip 20 shown in FIG. 2 provided in embodiments of this application, the first isolation barrier wall 211 is located between the first transistor column 221 and the second transistor column 222, and in either of the first transistor column 221 and the second transistor column 222, the first signal line 2103 is disposed on a side that is of the gate dielectric layer 2102 or the vertical channel 2101 and that faces away from the first isolation barrier wall 211. Therefore, the vertical channel 2101 and a part of the first signal line 2103 that wraps the vertical channel 2101 may form a vertical transistor (for example, the first vertical transistor T1 or the second vertical transistor T2 shown in FIG. 5). The part of the first signal line 2103 that wraps the vertical channel 2101 may be a gate of the vertical transistor. Because a side that is of the vertical channel 2101 of the vertical transistor and that faces the first isolation barrier wall 211 is located on the side wall of the first isolation barrier wall 211, no gate is disposed on the side of the vertical channel 2101 that faces the first isolation barrier wall 211. In this way, in a first direction X, a gate is disposed on only one side of the vertical transistor, so that the chip 20 has miniaturization in the first direction X.

In addition, still as shown in FIG. 2, the vertical channel 2101 of the vertical transistor may be located on the side wall of the first isolation barrier wall 211, and the first isolation barrier wall 211 may support the vertical channel 2101. Therefore, processing difficulty in reducing a thickness of the vertical channel 2101 in the first direction X can be reduced, thereby improving miniaturization of the vertical transistor. For example, a size of the vertical transistor may be miniaturized to 45 nm or less than 40 nm, so that a size of the chip 20 having the vertical transistor is effectively miniaturized to 6F² to 4F². A minimum processing size of the semiconductor is F.

In addition, still as shown in FIG. 2, the first signal line 2103 wraps the vertical channel on three sides, to cover the first signal line 2103 on three sides in a three-dimensional manner, so that electric field lines of the vertical transistor are more concentrated. This helps improve a gate control capability and an on-state current of the vertical transistor, and improve performance of the vertical transistor, thereby improving, when a requirement for a miniature size of a component in the electronic device is met, performance of the vertical transistor and the chip 20.

For example, an on-state current of the first vertical transistor T1 or the second vertical transistor T2 may be 100 nA to 1000 µA. An off-state leakage current of the first vertical transistor T1 or the second vertical transistor T2 may be 0.1 fA to 100 pA. A gate turn-on voltage of the first vertical transistor T1 or the second vertical transistor T2 may be 1 V to 5 V. A gate threshold voltage of the first vertical transistor T1 or the second vertical transistor T2 may be -0.5 V to 0.7 V.

In addition, both the gate dielectric layer 2102 and the first signal line 2103 may continuously cover the plurality of vertical channels 2101, and the part of the first isolation barrier wall 211 between the plurality of vertical channels 2101. Therefore, in a direction (that is, a second direction Y) in which the plurality of vertical channels 2101 are arranged, both the gate dielectric layer 2102 and the first signal line 2103 are continuous structures. In this way, in a manufacturing procedure, the plurality of vertical channels 2101 spaced from each other may be first formed on two sides of the first isolation barrier wall, and then the gate dielectric layer 2102 and the first signal line 2103 are sequentially formed on a side of a plurality of vertical channels 2101 in any row that faces away from the first isolation barrier wall 211. This helps simplify a manufacturing process.

In this embodiment of this application, the first vertical transistor T1 or the second vertical transistor T2 in the chip 20 may be prepared through a front end of line (front end of line, FEOL) process or a back end of line (back end of line, BEOL) process. This is not limited in this application. For example, when the first vertical transistor T1 or the second vertical transistor T2 is prepared through the front end of line process, the substrate 200 of the chip 20 may be a silicon substrate or a sapphire substrate of a wafer. In addition, when the first vertical transistor T1 or the second vertical transistor T2 is prepared through the back end of line process, the substrate 200 may be manufactured on a wafer.

It can be learned from the foregoing description that the chip 20 in FIG. 2 may be the foregoing logic chip. In this case, the first vertical transistor T1 or the second vertical transistor T2 in the chip 20 may be prepared through the front end of line process. Alternatively, when the chip 20 in FIG. 2 is the foregoing storage chip, the first vertical transistor T1 or the second vertical transistor T2 in the chip 20 may be prepared through the front end of line process, or may be prepared through the back end of line process.

On this basis, when the first vertical transistor T1 or the second vertical transistor T2 in the chip 20 is prepared through the back end of line process, a semiconductor material used by the vertical channel 2101 of the vertical transistor is poly-silicon (poly-silicon, Poly-Si). In comparison with a vertical transistor prepared by monocrystalline silicon through the front end of line process, mobility is attenuated. However, it can be learned from the foregoing description that the vertical transistor in the chip 20 shown in FIG. 2 has a high gate control capability and an on-state current. Therefore, even if the vertical transistor is prepared through the back end of line process, a chip 20 with high performance can still be obtained.

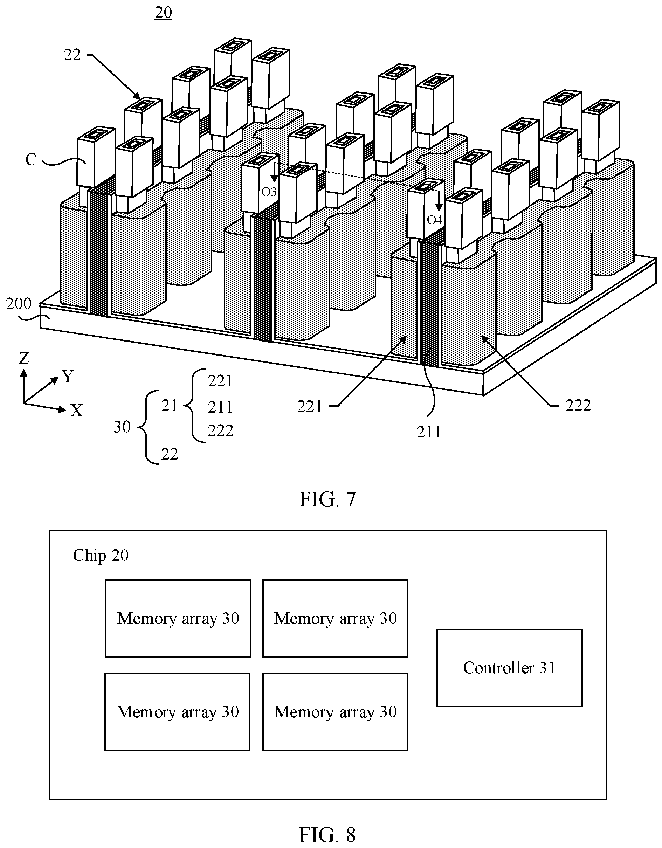

The following uses an example in which the chip 20 is a storage chip to describe a structure of the storage chip. In this case, the storage chip in the electronic device 01 provided in embodiments of this application may be a storage chip, for example, the first RAM 132 or the second RAM 103 in FIG. 1. An application scenario of the storage chip is not limited in this application. In some embodiments of this application, as shown in FIG. 7, the chip 20 may further include a capacitor array 22. The capacitor array 22 may be disposed on a side of the array structure 21 that faces away from the substrate 200. The capacitor array 22 is electrically connected to at least one of the first transistor column 221 or the second transistor column 222, to form a memory array 30. The capacitor array 22 may include a plurality of memory capacitors C arranged in an array.

On this basis, as shown in FIG. 8, when the chip 20 is a storage chip, the chip 20 may further include a controller 31 electrically connected to the plurality of memory arrays 30. The controller 31 may be configured to control a read/write operation on the memory array 30, to implement access to the memory array 30.

For example, in the chip 20, the memory array 30 and the controller 31 may be two chips independent of each other. The memory array 30 and the controller 31 may be separately disposed on a bearing plate (for example, a packaged transistor chain or a transfer plate), and the memory array 30 and the controller 31 are electrically connected to the bearing plate. In this way, the memory array 30 and the controller 31 may implement signal transmission through a metal cable in the bearing plate. On this basis, the chip 20 having the memory array 30 may be referred to as a stand-alone (stand-alone) storage chip.

Alternatively, for another example, in the foregoing chip 20, the memory array 30 and the controller 31 may be two chips independent of each other, and the memory array 30 and the controller 31 are disposed on the bearing plate in a stacked manner. The memory array 30 and the controller 31 may be electrically connected through a through silicon via (through silicon via, TSV) or a redistribution layer (redistribution layer, RDL), so that the memory array 30 and the controller 31 may perform signal transmission with the bearing plate. Similarly, the chip 20 having the memory array 30 is the stand-alone storage chip. Alternatively, for another example, in the chip 20, the memory array 30 and the controller 31 may be integrated into a same chip, and the integrated chip is electrically connected to the bearing plate. On this basis, the chip 20 having the memory array 30 may be referred to as an embedded storage chip.

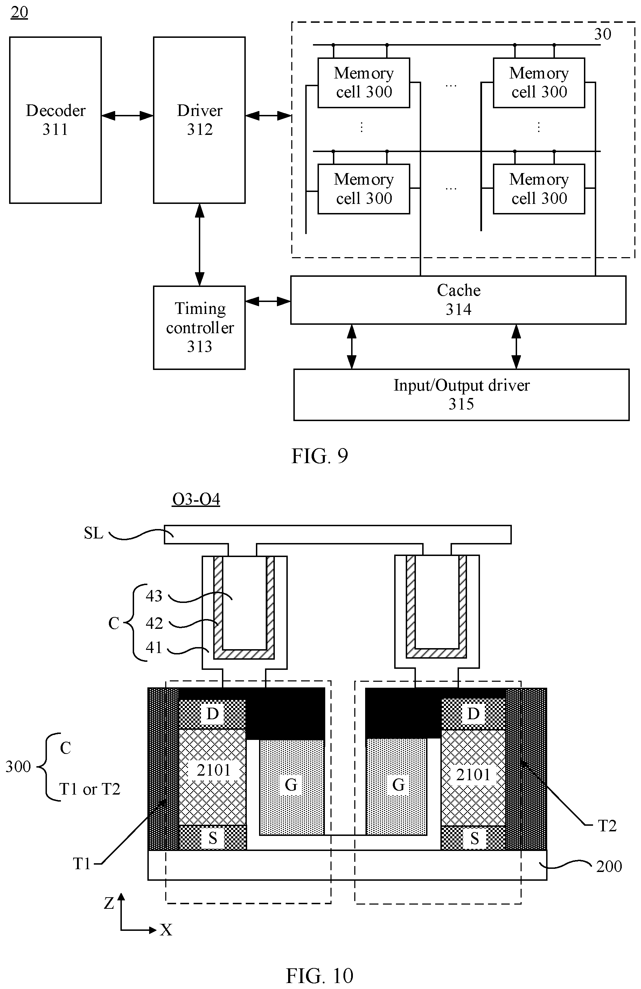

On this basis, as shown in FIG. 9, the memory array 30 may include a plurality of memory cells (cell) 300, and each memory cell 300 may be configured to store 1-bit (bit) or multibit data. For example, when the memory array 30 mainly includes the capacitor array 22 and the array structure 21 (including the first transistor column 221 and the second transistor column 222) shown in FIG. 7, the memory cell 300 shown in FIG. 9 may include a first vertical transistor T1 and a memory capacitor C electrically connected to the first vertical transistor T1 shown in FIG. 10. Alternatively, the memory cell 300 may include a second vertical transistor T2 and a memory capacitor C electrically connected to the second vertical transistor T2 in FIG. 10.

For example, the memory capacitor C shown in FIG. 7 or FIG. 10 is a columnar capacitor, and the columnar capacitor may be a cube shown in FIG. 7. Alternatively, the columnar capacitor may be a cylinder. A shape of the columnar capacitor is not limited in this application. In addition, still as shown in FIG. 10, the columnar memory capacitor C may include a bottom electrode (bottom electrode, BE) 41, a top electrode (top electrode, TE) 43, and a dielectric layer 42. At least a part of the top electrode 43 is disposed in the bottom electrode 41. At least a part of the dielectric layer 42 is disposed in the bottom electrode 41, and the dielectric layer 42 is located between the bottom electrode 41 and the top electrode 43. In some embodiments of this application, a material of the bottom electrode 41 or the top electrode 43 may include at least one of tungsten (W), titanium nitride (TiN), and molybdenum (Mo).

In some embodiments of this application, the dielectric layer 42 may be a ferroelectric thin film layer, or may be referred to as a ferroelectric dielectric layer (ferroelectric insulator). In this case, the memory capacitor C may be a ferroelectric capacitor (FeCAP), and the chip 20 having the ferroelectric capacitor may be a ferroelectric random access memory (ferroelectric random access memory, FeRAM or FRAM).

Alternatively, in some other embodiments of this application, the dielectric layer 42 may be a resistive switching layer. In this case, the memory capacitor C may be a resistive random access capacitor, and the chip 20 having the resistive random access capacitor may be a resistive random access memory (resistive random access memory, RRAM). Alternatively, in some other embodiments of this application, the dielectric layer 42 may be a phase change material layer. In this case, the chip 20 may be a phase change memory (phase change memory, PCM).

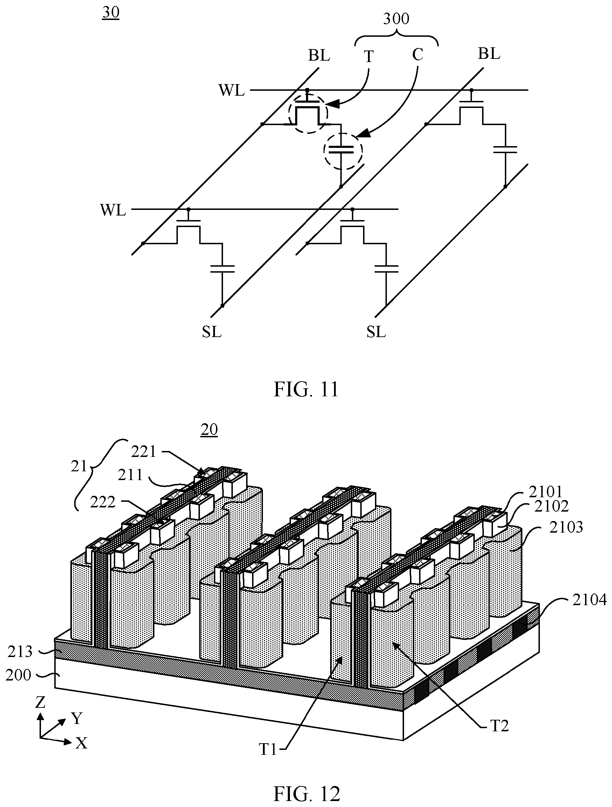

In the memory cell 300, the bottom electrode (namely, the bottom electrode 41) of the memory capacitor C may be electrically connected to the second electrode, for example, the drain D, of the first vertical transistor T1 or the second vertical transistor T2. Top electrodes 43 of different memory cells 300 may be electrically connected through a signal line SL. The memory cell 300 shown in FIG. 10 is described by using a 1T1C (one transistor and one capacitor) structure, to be specific, one transistor T (for example, the first vertical transistor T1 or the second vertical transistor T2) and one memory capacitor C shown in FIG. 11 as an example. A quantity of transistors and a quantity of memory capacitors C in the memory cell 300 are not limited in embodiments of this application. For example, the memory cell 300 may also be of a 2T1C (two transistor and one capacitor) structure or a 2T0C (two transistor and zero capacitor) structure.

Still as shown in FIG. 11, it can be learned from the foregoing description that a control end (for example, a gate) of the transistor T may be electrically connected to the first signal line 2103 shown in FIG. 2, and the first signal line 2103 may be used as a word line (word line, WL). A first electrode (for example, a source S) of the transistor T may be electrically connected to a second signal line, for example, a bit line (bit line, BL), and the top electrode 43 (as shown in FIG. 10) of the memory capacitor C is electrically connected to the signal line SL. One or more of the WL, the BL, and the SL are configured to select, by receiving a control level output by a control circuit, a to-be-read/written memory cell 300 in the memory array 30, to change a polarization direction of the memory capacitor C in the memory cell 300, to implement a data read/write operation.

In some other embodiments of this application, the memory capacitor C in the memory cell 300 may be replaced with a magnetic tunnel junction (magnetic tunnel junction, MTJ), and the chip 20 having the MTJ may be a magneto resistive random access memory (Magneto resistive Random Access Memory, MRAM). Alternatively, in some other embodiments of this application, the memory capacitor C in the memory cell 300 may be replaced with a ferroelectric capacitor.

In addition, the controller 31 shown in FIG. 8 may include one or more circuit structures of a decoder 311, a driver 312, a timing controller 313, a cache 314, or an input/output driver 315 shown in FIG. 9. The decoder 311 is configured to decode an address of the memory cell 300. The decoder 311 is configured to perform decoding based on a received address, to determine a memory cell 300 that needs to be accessed. The driver 312 is configured to control a level of a signal line based on a decoding result generated by the decoder 311, to access the specified memory cell 300. The cache 314 is configured to cache read data, for example, may cache the data in a first-in first-out (first-in first-out, FIFO) manner. The timing controller 313 is configured to control a time sequence of the cache 314, and control a time sequence of a signal line in the memory cell 300 that is driven by the driver 312. The input/output driver 315 is configured to drive a transmission signal, for example, drive a received data signal and drive a data signal that needs to be sent, so that the data signals can be transmitted over a long distance. The memory array 30, the decoder 311, the driver 312, the timing controller 313, the cache 314, and the input/output driver 315 may be integrated into one chip, or may be respectively integrated into a plurality of chips.

When the chip 20 is a storage chip, a first electrode (for example, a source S) of the first vertical transistor T1 or the second vertical transistor T2 shown in FIG. 10 may be electrically connected to the second signal line shown in FIG. 11, for example, the BL. On this basis, in some embodiments of this application, when the chip 20 is manufactured through the front end of line process, the first vertical transistor T1 or the second vertical transistor T2 may be first formed on the substrate 200, and then the second signal line, for example, the BL, is formed.

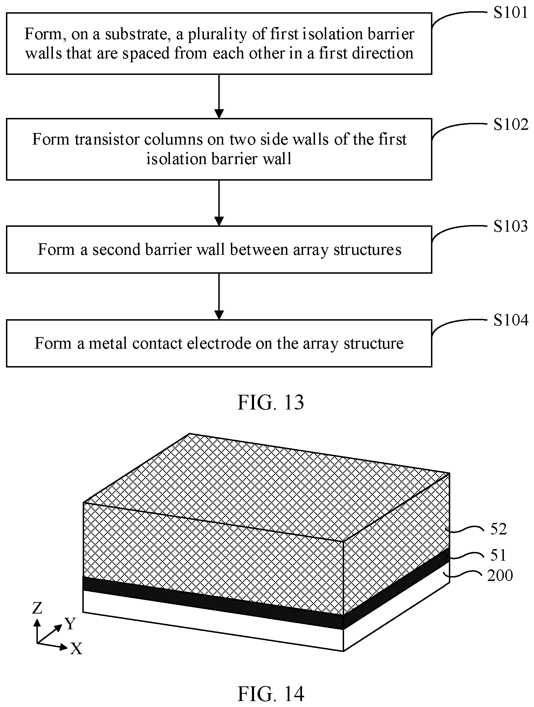

Alternatively, in some other embodiments of this application, when the chip 20 is manufactured through the back end of line process, as shown in FIG. 12, a second signal line 2104, for example, the BL, may be first manufactured on the substrate 200, and then the first vertical transistor T1 or the second vertical transistor T2 is manufactured. The following describes, by using an example, a manufacturing method for the chip 20 shown in FIG. 12. The foregoing manufacturing method may include S101 to S104 shown in FIG. 13.

S101: Form, on a substrate, a plurality of first isolation barrier walls that are spaced from each other in a first direction.

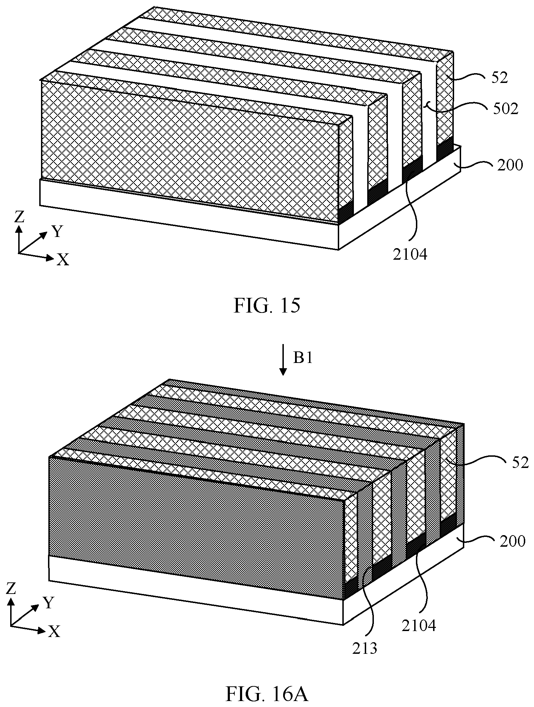

For example, as shown in FIG. 14, a first metal material layer 51 and a semiconductor material layer 52 are first sequentially formed on the substrate 200. Next, on the semiconductor material layer 52, a part of the first metal material layer 51 and a part of the semiconductor material layer 52 shown in FIG. 14 may be removed through an etching process, to form a plurality of second trenches 502 extending in the first direction X shown in FIG. 15. An upper surface of the substrate 200 may be exposed from the bottom of the second trench 502. In this case, a part of the metal material layer between two adjacent second trenches 502 may be used as the second signal line 2104 (for example, the BL in FIG. 11).

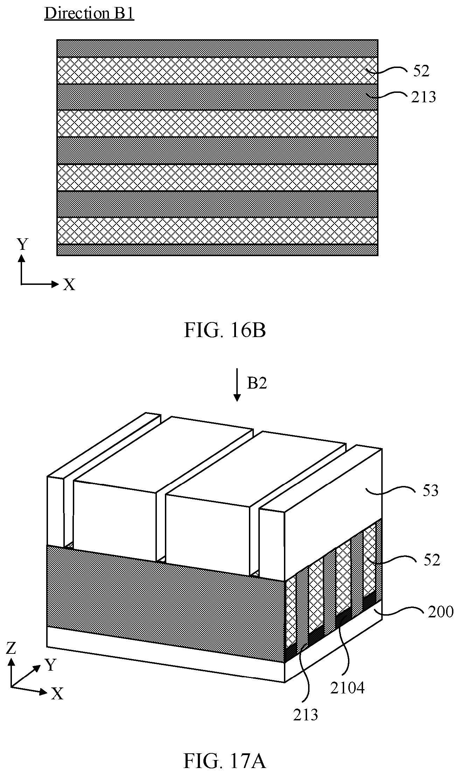

Then, a dielectric material may be filled in the second trench 502 through a deposition process, to form a third isolation barrier wall 213 shown in FIG. 16A. In this case, the third isolation barrier wall 213 may be disposed between two adjacent second signal lines 2104, to isolate the adjacent second signal lines 2104. In addition, a material of the third isolation barrier wall 213 may be different from a material of the first isolation barrier wall 211 in FIG. 12. For example, the material of the first isolation barrier wall 211 may be silicon nitride, and the material of the third isolation barrier wall 213 may be silicon oxide. Alternatively, the material of the first isolation barrier wall 211 may be silicon oxide, and the material of the third isolation barrier wall 213 may be silicon nitride. In this way, in a subsequent procedure of performing wet etching on the third isolation barrier wall 213, a structure of the first isolation barrier wall 211 is not affected. On this basis, as shown in FIG. 16B (a top view taken along a direction B1 in FIG. 16A), the semiconductor material layer 52 is separated into a plurality of strip structures by a plurality of third isolation barrier walls 213 extending in the first direction X.

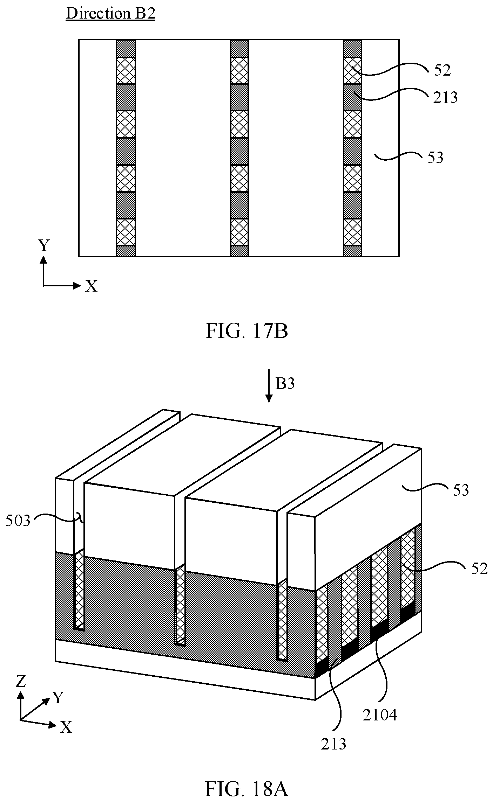

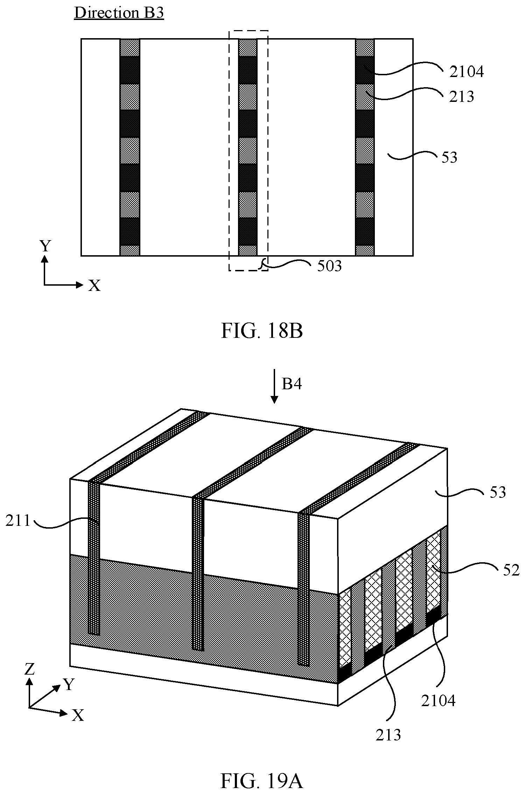

Next, as shown in FIG. 17A, a first mask structure 53 is formed on the semiconductor material layer 52. As shown in FIG. 17B (a top view taken along a direction B2 in FIG. 17A), a part of the semiconductor material layer 52 and a part of the third isolation barrier wall 213 may be exposed from a hollow part of the first mask structure 53. Then, the first mask structure 53 is used as a mask (mask) to perform a photolithography process on a film layer below the first mask structure 53, to remove the semiconductor material layer 52 and the third isolation barrier wall 213 that are exposed by the first mask structure 53, so as to form a plurality of third trenches 503 that are spaced from each other in the first direction X and that are shown in FIG. 18A. As shown in FIG. 18B (a top view taken along a direction B3 in FIG. 18A), a part of the second signal line 2104 and the third isolation barrier wall 213 disposed between adjacent second signal lines 2104 may be exposed at the bottom of the third trench 503.

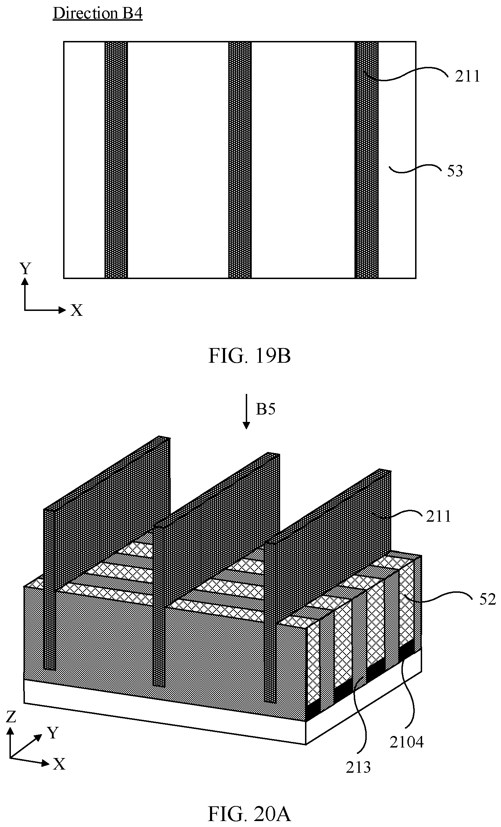

Next, the third trench 503 shown in FIG. 18A may be filled with a dielectric material through a deposition process, to form the first isolation barrier wall 211 shown in FIG. 19A. As shown in FIG. 19B (a top view taken along a direction B4 in FIG. 19A), the first isolation barrier wall 211 is located in the hollow part of the first mask structure 53, so that the plurality of first isolation barrier walls 211 are spaced from each other in the first direction X, and the first isolation barrier wall 211 extends in a second direction Y.

S102: Form transistor columns on two side walls of the first isolation barrier wall.

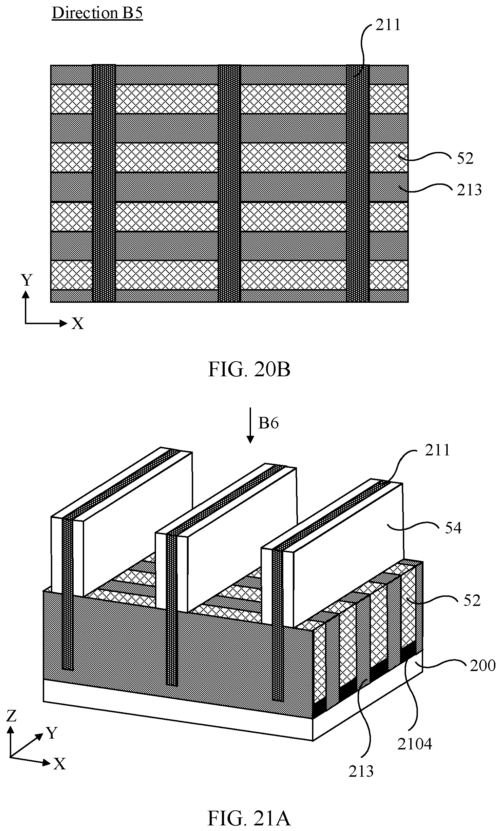

For example, the first mask structure 53 shown in FIG. 19A may be first removed, so that a part of the first isolation barrier wall 211 shown in FIG. 20A is located in the semiconductor material layer 52 and the third isolation barrier wall 213, while another part of the first isolation barrier wall 211 extends out of the semiconductor material layer 52 and the third isolation barrier wall 213. On this basis, as shown in FIG. 20B (a top view taken along a direction B5 in FIG. 20A), a part of the semiconductor material layer 52 and a part of the third isolation barrier wall 213 may be exposed between two adjacent first isolation barrier walls 211.

Next, as shown in FIG. 21A, a second mask structure 54 is formed on the side wall of the first isolation barrier wall 211. It can be learned from the foregoing description that, the first mask structure 53 shown in FIG. 19A is used as a mask, and the first isolation barrier wall 211 shown in FIG. 21A is formed through a photolithography process and a deposition process. The first isolation barrier wall 211 has high precision in size and location, and a spacing between the plurality of first isolation barrier walls 211 is also highly accurate. On this basis, the second mask structure 54 formed on the side wall of the first isolation barrier wall 211 may be self-aligned using the first isolation barrier wall 211, so that the second mask structure 54 with high precision in size, location, and spacing can be formed.

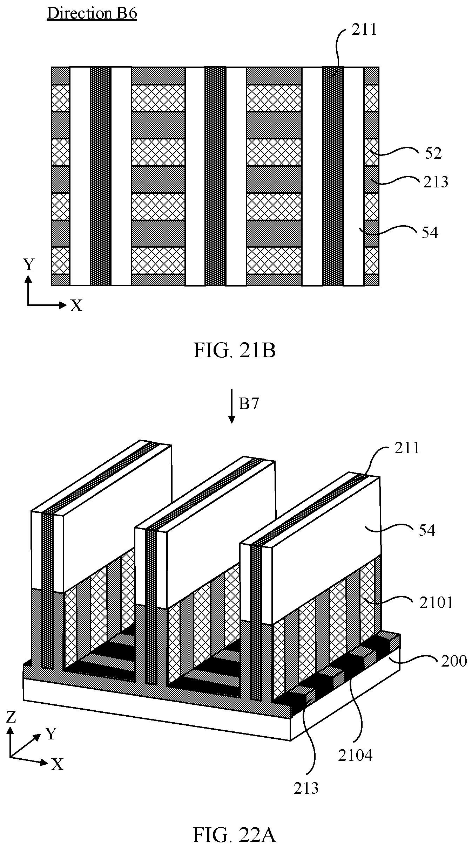

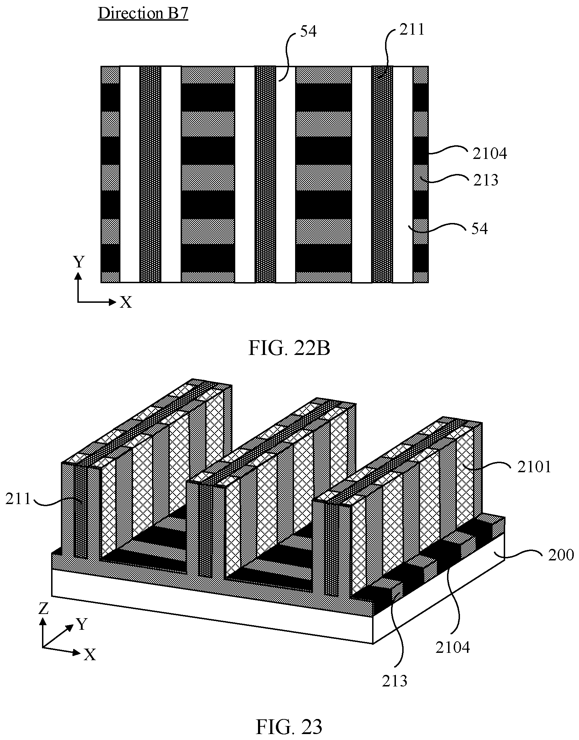

In addition, as shown in FIG. 21B (a top view taken along a direction B6 in FIG. 21A), a part of the semiconductor material layer 52 and a part of the third isolation barrier wall 213 may be exposed from a hollow part of the second mask structure 54. Then, the second mask structure 54 is used as a mask (mask) to perform a photolithography process on a film layer below the second mask structure 54, to remove the semiconductor material layer 52 and the third isolation barrier wall 213 that are exposed by the second mask structure 54. A remaining part of the semiconductor material layer 52 may form a vertical channel 2101 shown in FIG. 22A, and the vertical channel 2101 is perpendicular to the substrate 200. On this basis, as shown in FIG. 22B (a top view taken along a direction B7 in FIG. 22A), a part of the second signal line 2104 and the third isolation barrier wall 213 may be exposed between two adjacent second mask structures 54.

It can be learned from the foregoing that the second mask structure 54 formed on the side wall of the first isolation barrier wall 211 may be self-aligned using the first isolation barrier wall 211, and therefore, the second mask structure 54 with high precision in size, location, and spacing can be obtained. In this case, the second mask structure 54 with high precision in size, location, and spacing is used as a mask, and the formed vertical channel 2101 may also have high precision in size, location, and spacing.

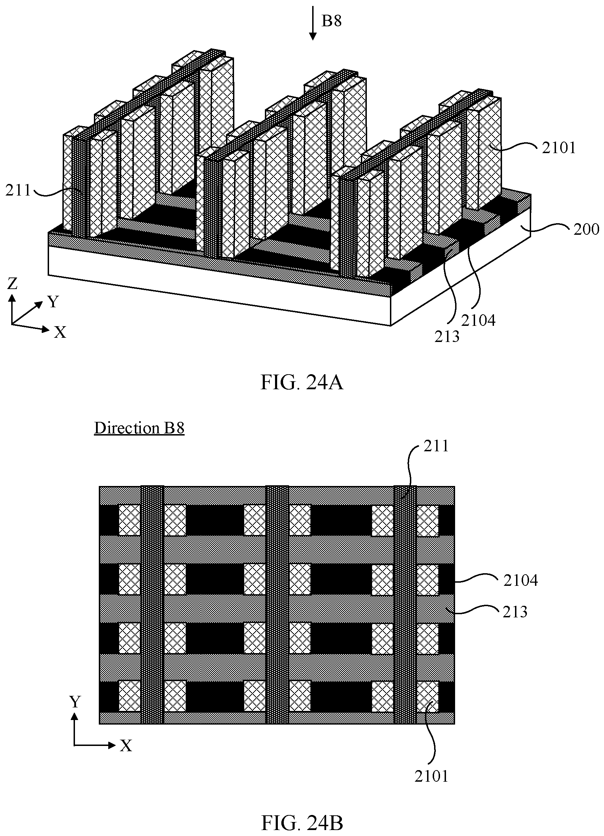

Next, a chemical mechanical polishing (chemical mechanical polishing, CMP) process may be used to remove the second mask structure 54 on the top of the vertical channel 2101, and the part that protrudes from the vertical channel 2101 in the first isolation barrier wall 211, so that an upper surface of the first isolation barrier wall 211 may be flush with an upper surface of the vertical channel 2101, as shown in FIG. 23. Next, it can be learned from the foregoing that the first isolation barrier wall 211 and the third isolation barrier wall 213 are made of different materials. Therefore, the third isolation barrier wall 213 between two adjacent vertical channels 2101 may be removed through a wet etching process, so that a gap exists between the two adjacent vertical channels 2101, as shown in FIG. 24A. In addition, in the foregoing wet etching process, the third isolation barrier wall 213 between two adjacent second signal lines 2104 may be reserved by controlling a related parameter of the wet etching process, for example, etching time.

On this basis, as shown in FIG. 24B (a top view taken along a direction B8 in FIG. 24A), a plurality of vertical channels 2101 that are spaced from each other in the second direction Y may be formed on two opposite side walls of the first isolation barrier wall 211. In addition, a vertical projection of a vertical channel 2101 on the substrate 200 in FIG. 24A may overlap a vertical projection of a second signal line 2104 on the substrate 200.

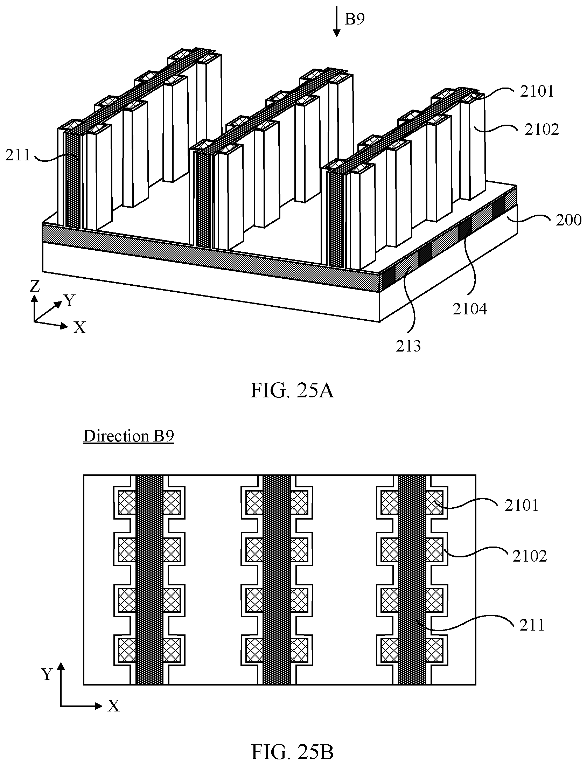

On this basis, as shown in FIG. 25A, a gate dielectric layer 2102 is formed on a side of the plurality of vertical channels 2101 that faces away from the isolation barrier wall 211. As shown in FIG. 25B (a top view taken along a direction B9 in FIG. 25A), the gate dielectric layer 2102 wraps the vertical channel 2101 on three sides, and the gate dielectric layer 2102 continuously covers the plurality of vertical channels 2101, and a part of the first isolation barrier wall 211 between the plurality of vertical channels 2101.

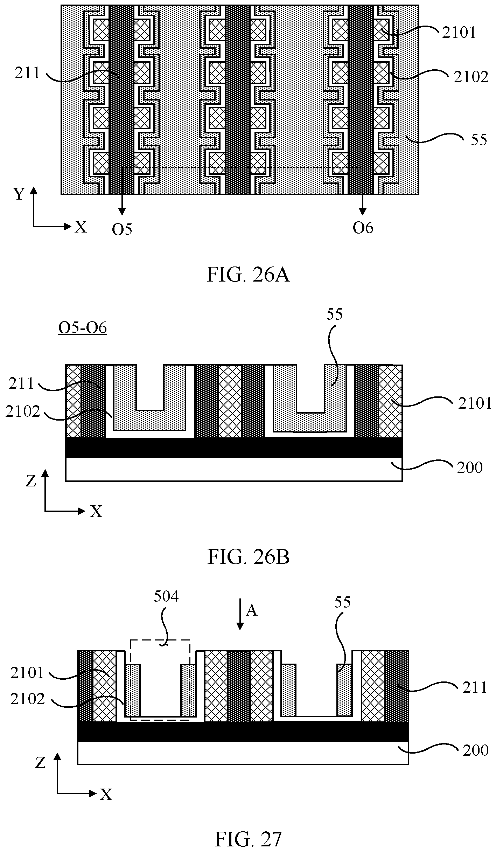

Next, as shown in FIG. 26A, a second metal material layer 55 is formed on a side of the gate dielectric layer 2102 that faces away from the first isolation barrier wall 211. In some embodiments of this application, as shown in FIG. 26B (a sectional view obtained by performing sectioning along a dashed line O5-O6 in FIG. 26A), the second metal material layer 55 may cover the gate dielectric layer 2102 with a uniform thickness.

On this basis, it can be learned from the foregoing that the gate dielectric layer 2102 shown in FIG. 26A wraps the vertical channel 2101 on three sides, and the gate dielectric layer 2102 continuously covers the plurality of vertical channels 2101, and the part of the first isolation barrier wall 211 between the plurality of vertical channels 2101. Therefore, the second metal material layer 55 formed on the gate dielectric layer 2102 may be conformal (conformal) with the gate dielectric layer 2102, that is, a shape of the second metal material layer 55 may be the same as or approximately the same as a shape of the gate dielectric layer 2102. In this way, the second metal material layer 55 may also wrap the vertical channel 2101 on three sides, and the gate dielectric layer 2102 continuously covers the plurality of vertical channels 2101, and the part of the first isolation barrier wall 211 between the plurality of vertical channels 2101.

Next, as shown in FIG. 27, the bottom of a part of the second metal material layer 55 between two adjacent first isolation barrier walls 211 is cut open (bottom open) to form a fourth trench 504. As shown in FIG. 3 (a top view taken along a direction A in FIG. 27), a part of the gate dielectric layer 2102 may be exposed at the bottom of the fourth trench 504. In this case, a remaining part of the second metal material layer 55 in FIG. 27 may form the first signal line 2103 in FIG. 3. Because the second metal material layer 55 is conformal with the gate dielectric layer 2102, the first signal line 2103 is also conformal with the gate dielectric layer 2102, so that the first signal line 2103 wraps the vertical channel 2101 on three sides, and the first signal line 2103 continuously covers the plurality of vertical channels 2101, and the part of the first isolation barrier wall 211 between the plurality of vertical channels 2101.

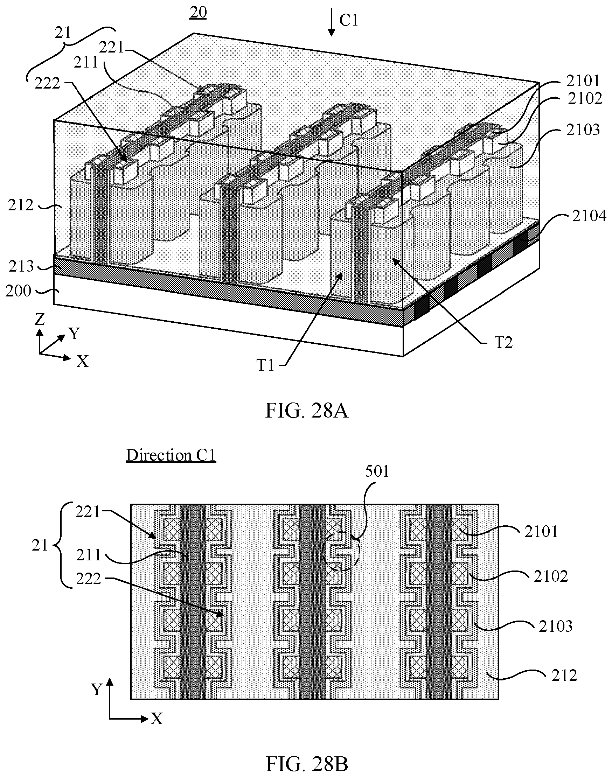

In this case, as shown in FIG. 28A, a part of the gate dielectric layer 2102 and a part of the first signal line 2103 that wrap the vertical channel 2101 on three sides and one vertical channel 2101 located on one side of the first isolation barrier wall 211 may form one first vertical transistor T1. A plurality of first vertical transistors T1 are spaced from each other in the second direction Y, to form a first transistor column 221. In addition, a part of the gate dielectric layer 2102 and a part of the first signal line 2103 that wrap the vertical channel 2101 on three sides and one vertical channel 2101 located on the other side of the first isolation barrier wall 211 may form a second transistor column 222. A plurality of second vertical transistors T2 are spaced from each other in the second direction Y, to form a second transistor column 222. The first transistor column 221 and the second transistor column 222 are respectively disposed on two sides of the first isolation barrier wall 211.

It can be learned from the foregoing description that a size, a location, and a spacing of the vertical channel 2101 may also have high precision. Therefore, sizes of the foregoing transistor columns having the vertical channel 2101, such as the first transistor column 221 and the second transistor column 222, may also have high precision. This helps improve miniaturization of the transistor columns and the chip 20 having the transistor columns.

S103: Form a second barrier wall between array structures.

For example, still as shown in FIG. 28A, the second isolation barrier wall 212 is formed on the substrate 200 having a plurality of array structures 21. A part of the isolation barrier wall 212 covers a surface of the array structure 21 that faces away from the substrate 200, and a part of the isolation barrier wall 212 is located between two adjacent array structures 21. Two adjacent first signal lines 2103 that respectively belong to different array structures 21 are isolated on two sides of the second isolation barrier wall 212. Two adjacent vertical channels 2101 of different array structures 21 are isolated on two sides of the second isolation barrier wall 212. The second isolation barrier wall 212 may isolate two adjacent first signal lines 2103 in different array structures 21. In addition, the second isolation barrier wall 212 may further isolate two adjacent vertical channels 2101 in different array structures 21.

It can be learned from the foregoing that the first signal line 2103 continuously covers the part of the first isolation barrier wall 211 between the plurality of vertical channels 2101. Therefore, as shown in FIG. 28B (a top view taken along a direction C1 in FIG. 28A), the first signal line 2103 covers the part of the first isolation barrier wall 211, and a first trench 501 is provided on a side facing away from the first isolation barrier wall 211. A part of the second isolation barrier wall 212 located between two adjacent array structures 21 is located in the first trench 501. In this case, in FIG. 28B, a top-view structure of the second isolation barrier wall 212 located between two adjacent array structures 21 may be similar to a shape of " 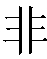 " (a Chinese character).

S104: Form a metal contact electrode on the array structure.

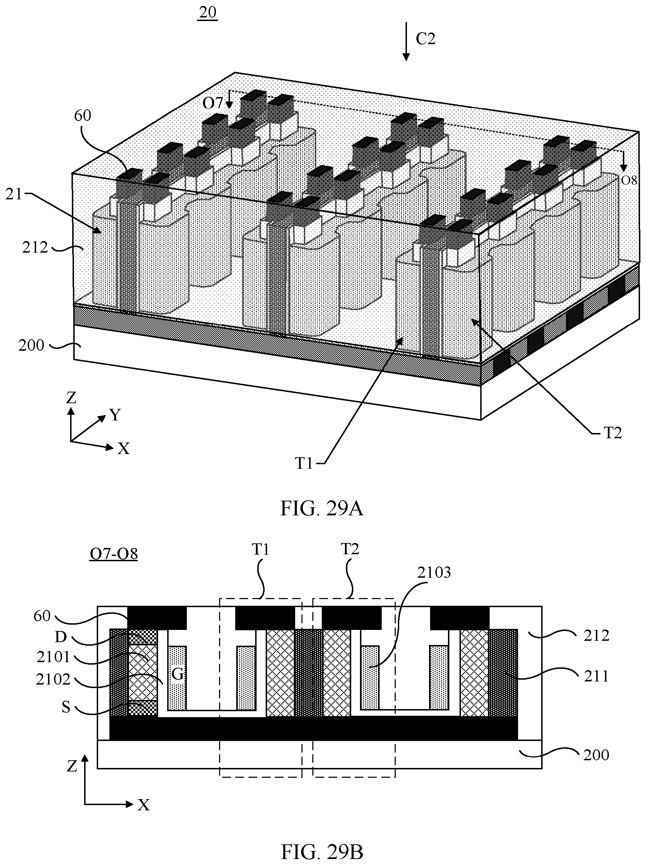

For example, as shown in FIG. 29A, the first signal line 2103 is first etched, to reduce a height of the first signal line 2103 in a third direction Z. Then, a plurality of metal contact electrodes 60 are formed on the plurality of array structures 21. One metal contact electrode 60 may be electrically connected to one vertical transistor, for example, the first vertical transistor T1 or the second vertical transistor T2. In addition, the metal contact electrode 60 is isolated from the first signal line 2103 via the second isolation barrier wall 212.

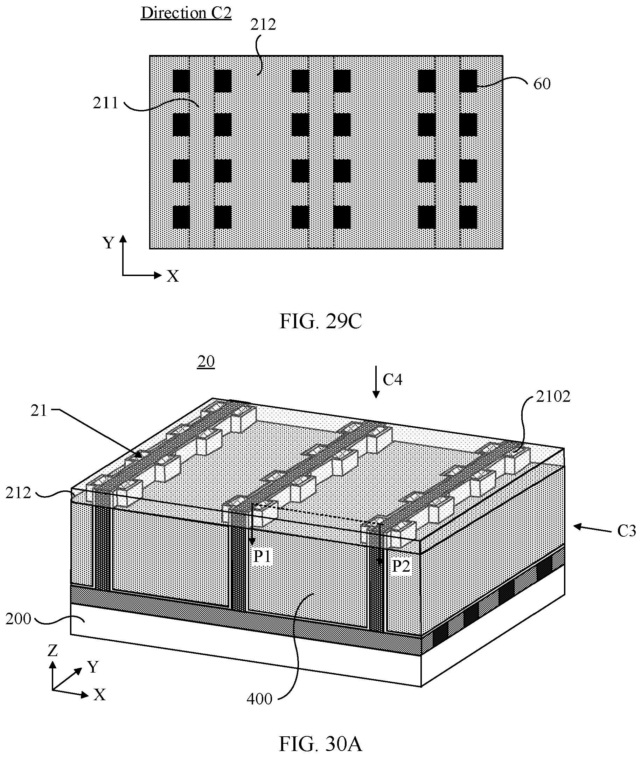

For example, as shown in FIG. 29B (a sectional view obtained by performing sectioning along a dashed line O7-O8 in FIG. 29A), a second electrode, for example, a drain D (as shown in FIG. 10), of the first vertical transistor T1 or the second vertical transistor T2, is electrically connected to the metal contact electrode 60. In this case, as shown in FIG. 29C (a top view taken along a direction C2 in FIG. 29A), a plurality of metal contact electrodes 60 spaced from each other in the second direction Y may be arranged on the side wall of the first isolation barrier wall 211.

It can be learned from the foregoing description that, as shown in FIG. 26B, the second metal material layer 55 may cover the gate dielectric layer 2102 with a uniform thickness. Next, as shown in FIG. 27, the bottom of the part of the second metal material layer 55 between the two adjacent first isolation barrier walls 211 is cut open, to form the first signal line 2103 in FIG. 29B. Therefore, two adjacent first signal lines 2103 that respectively belong to different array structures 21 are separated via the second isolation barrier wall 212 located between the two first signal lines 2103.

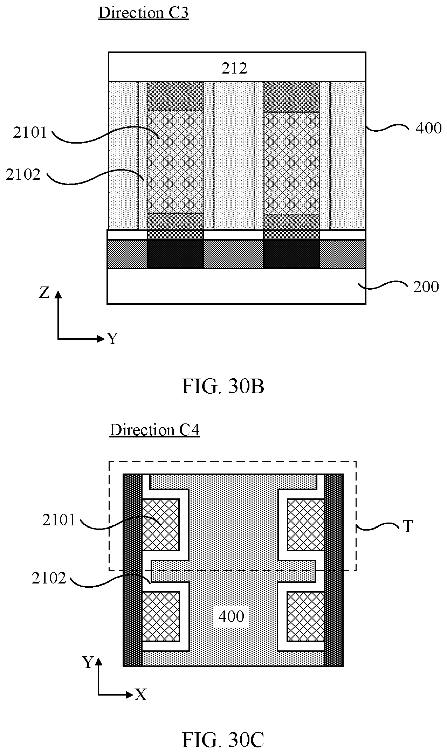

In some other embodiments of this application, two adjacent first signal lines 2103 (as shown in FIG. 29B) that respectively belong to different array structures 21 are connected to an integrated conductive structural part 400 shown in FIG. 30A, and the integrated conductive structural part 400 is filled between two adjacent rows of vertical channels 2101. In this case, as shown in FIG. 30B (a side view taken along a direction C3 in FIG. 30A), a plurality of vertical channels 2101 located in a same row in the second direction Y are covered by the integrated conductive structural part 400. In addition, still as shown in FIG. 30A, the second isolation barrier wall 212 of the chip 20 may be disposed between two adjacent array structures 21, and the second isolation barrier wall 212 may be located on a side of the integrated conductive structural part 400 that faces away from the substrate 200. The second isolation barrier wall 212 is configured to isolate a part of the vertical channel 2101 that is in the two adjacent array structures 21 and that is not covered by the integrated conductive structural part 400.

In this case, as shown in FIG. 30C (a top view taken along a direction C4 in FIG. 30A), the integrated conductive structural part 400 and two oppositely disposed vertical channels 2101 surrounded by the integrated conductive structural part 400 may form a dual-channel vertical transistor T. In comparison with a single-channel vertical transistor, an on-state current of the dual-channel vertical transistor T may be doubled.

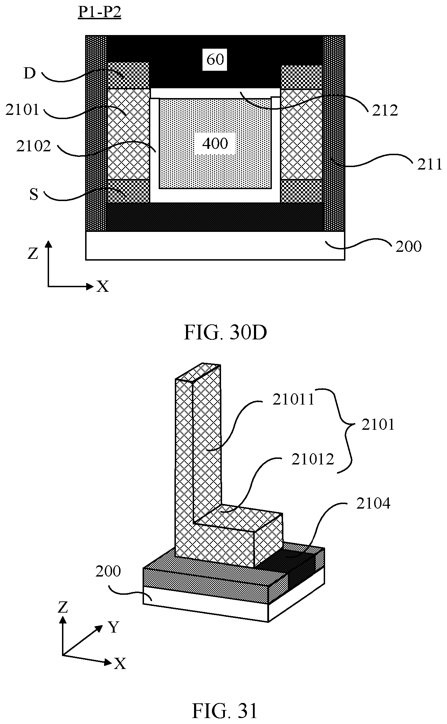

To manufacture the integrated conductive structural part 400, as shown in FIG. 30D (a sectional view obtained by performing sectioning along a dashed line P1-P2 in FIG. 30A), after the gate dielectric layer 2102 is formed, the second metal material layer (a material used to form the integrated conductive structural part 400) is formed on the gate dielectric layer 2102. The second metal material layer does not need to cover the gate dielectric layer 2102 with a uniform thickness, but is filled between two adjacent first isolation barrier walls 211, and covers the substrate 200 and a surface of the gate dielectric layer 2102 that faces away from the first isolation barrier wall 211.

Then, the second metal material layer is re-etched to form the integrated conductive structural part 400, so that a height of the integrated conductive structural part 400 in the third direction Z is less than a height of the second electrode, for example, the drain D, of the vertical transistor. In this way, after the metal contact electrode 60 is manufactured, the metal contact electrode 60 contacts the second electrode, for example, the drain D, of the vertical transistor, and the metal contact electrode 60 is isolated from the integrated conductive structural part 400 via the second isolation barrier wall 212.

It can be learned from the foregoing that, in FIG. 22A, the second mask structure 54 is used as a mask pair, to remove the semiconductor material layer 52 and the third isolation barrier wall 213 that are exposed by the second mask structure 54, and a remaining part of the semiconductor material layer 52 that is shielded by the second mask structure 54 may form the vertical channel 2101. Therefore, in the first direction X, a thickness of the second mask structure 54 is the same as a thickness of the vertical channel 2101, and the vertical channel 2101 is a cube structure perpendicular to the substrate 200. The following describes a vertical channel 2101 of another shape and a manufacturing method for the vertical channel 2101 by using examples.

In some other embodiments of this application, as shown in FIG. 31, the vertical channel 2101 may include a first part 21011 and a second part 21012. The first part 21011 is disposed in a direction perpendicular to the substrate 200, and the second part 21012 is connected to an end of the first part 21011 that faces the substrate 200. The second part 21012 is disposed in the first direction X, and the second part 21012 is in contact with the second signal line 2104, so that the second part 21012 can be electrically connected to the second signal line 2104. In this way, because the second part 21012 is electrically connected to the second signal line 2104, and the second part 21012 is disposed in the first direction X, the second part 21012 can increase a contact area between the entire vertical channel 2101 and the second signal line 2104, thereby reducing a contact resistance.

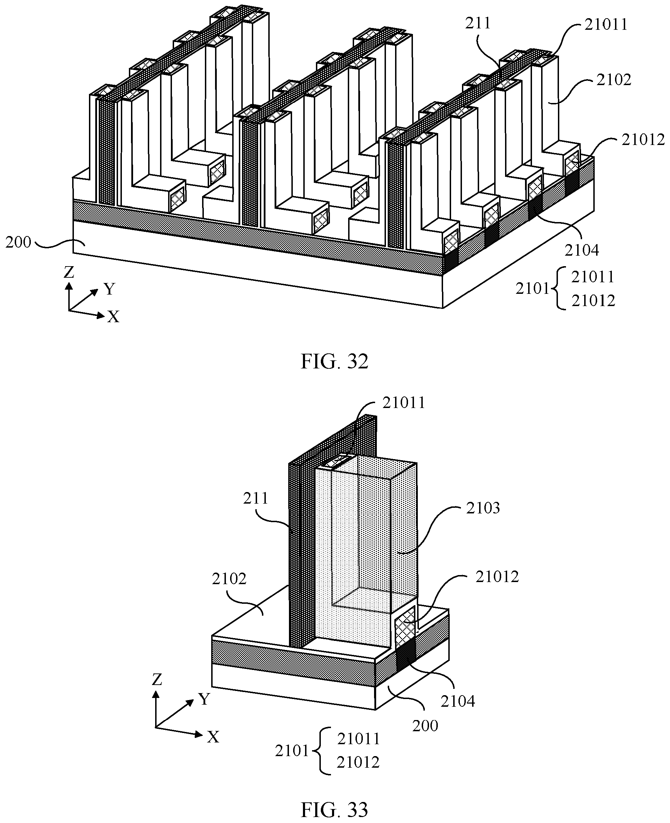

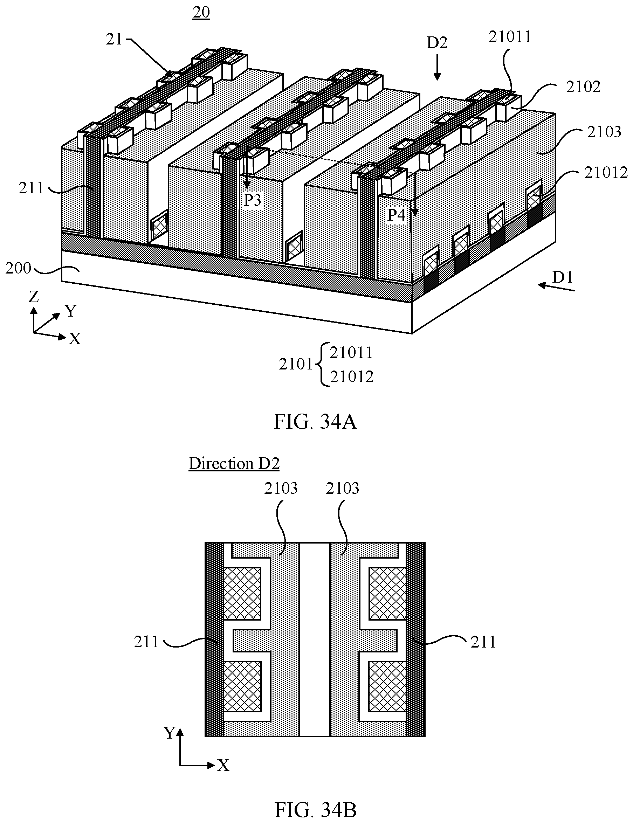

In this case, still as shown in FIG. 31, the first part 21011 and the second part 21012 in the vertical channel 2101 may form an L-shaped structure. In some embodiments of this application, as shown in FIG. 32, an end of the second part 21012 that faces away from the first isolation barrier wall 211 may be exposed by the gate dielectric layer 2102 that wraps the L-shaped vertical channel 2101 on three sides. In addition, as shown in FIG. 33, the first signal line 2103 covers a surface of the first part 21011 that faces away from the first isolation barrier wall 211, and the first signal line 2103 further covers surfaces of the first part 21011 and the second part 21012 that are perpendicular to the first isolation barrier wall 211 and the substrate 200. Therefore, as shown in FIG. 34A, a part of the first signal line 2103 that covers the second part 21012, when viewed from a D1 direction, is similar to a horseshoe shape, so that a coverage area of the first signal line 2103 can be increased, and a resistance of the first signal line 2103 can be reduced.

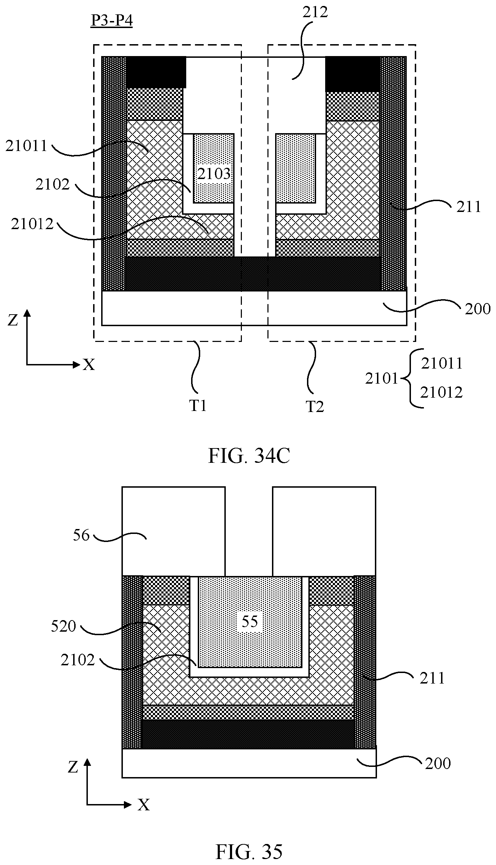

On this basis, as shown in FIG. 34B (a top view taken along a direction D2 in FIG. 34A), there is a gap between two first signal lines 2103 between adjacent first isolation barrier walls 211, so that the plurality of array structures 21 in FIG. 34A can be spaced from each other in the first direction X. In addition, a surface of the first signal line 2103 that faces away from the first isolation barrier wall 211 is a plane. As shown in FIG. 34C (a sectional view obtained by performing sectioning along a dashed line P3-P4 in FIG. 34A), a surface of a side of the first signal line 2103 that faces away from the first isolation barrier wall 211 is flush with a surface of a side that is of the second part 21012 of the vertical channel 2101 and that faces away from the first isolation barrier wall 211 and a surface of a side of the gate dielectric layer 2102 that faces away from the first isolation barrier wall 211.

On this basis, after the first mask structure 53 is formed (as shown in FIG. 19A), forming, on the side wall of the first isolation barrier wall 211 shown in FIG. 34C, the plurality of vertical channels 2101 that are spaced from each other in the second direction Y, and forming the gate dielectric layer 2102 and the first signal line 2103 may include: first, removing the first mask structure 53 (as shown in FIG. 19A), forming the second mask structure 54 on the side wall of the first isolation barrier wall 211 as shown in FIG. 21A, and removing a part of the semiconductor material layer 52 and the third isolation barrier wall 213 that are exposed by the second mask structure 54, to form a plurality of U-shaped semiconductor structures.

Removing the part of the semiconductor material layer 52 that is exposed by the second mask structure 54 means that the semiconductor material layer 52 exposed by the second mask structure 54 does not need to be completely etched, and a part of the semiconductor material layer 52 at the bottom is reserved, so that the semiconductor material layer 52 that is not etched is a U-shaped semiconductor structure 520 shown in FIG. 35. A part of the U-shaped semiconductor structure 520 is disposed in the first direction X, and is electrically connected to the second signal line 2104. Therefore, a contact area between the entire vertical channel 2101 and the second signal line 2104 can be increased, thereby reducing a contact resistance.

Then, still as shown in FIG. 35, the gate dielectric layer 2102 and the second metal material layer 55 are sequentially formed in the U-shaped semiconductor structure 520. As described above, the gate dielectric layer 2102 and the second metal material layer 55 each wrap the plurality of U-shaped semiconductor structures 520 on three sides, and both the gate dielectric layer 2102 and the second metal material layer 55 continuously cover the U-shaped semiconductor structure 520, and a part of the first isolation barrier wall 211 between the plurality of U-shaped semiconductor structures.

Then, still as shown in FIG. 35, a third mask structure 56 is formed on a side of the U-shaped semiconductor structure 520 that faces away from the substrate 200, and the third mask structure 56 is used as a mask to remove a part that is of the bottom of the U-shaped semiconductor structure 520 and that is exposed by the third mask structure 56, and remove a part of the gate dielectric layer 2102 and a part of the second metal material layer 55 that cover the bottom of the U-shaped semiconductor structure 520, to form the L-shaped vertical channel 2101, the gate dielectric layer 2102, and the first signal line 2103 shown in FIG. 34C. In this way, the third mask structure 56 is used as a mask, and the L-shaped vertical channel 2101, the gate dielectric layer 2102, and the first signal line 2103 may be formed simultaneously through the photolithography process.

On this basis, the second isolation barrier wall 212 is formed as shown in FIG. 34C. Two adjacent first signal lines 2103 that respectively belong to different array structures 21 (as shown in FIG. 34A) are isolated on two sides of the second isolation barrier wall 212. Two vertical channels 2101 that respectively belong to different array structures 21 are isolated on two sides of the second isolation barrier wall 212.

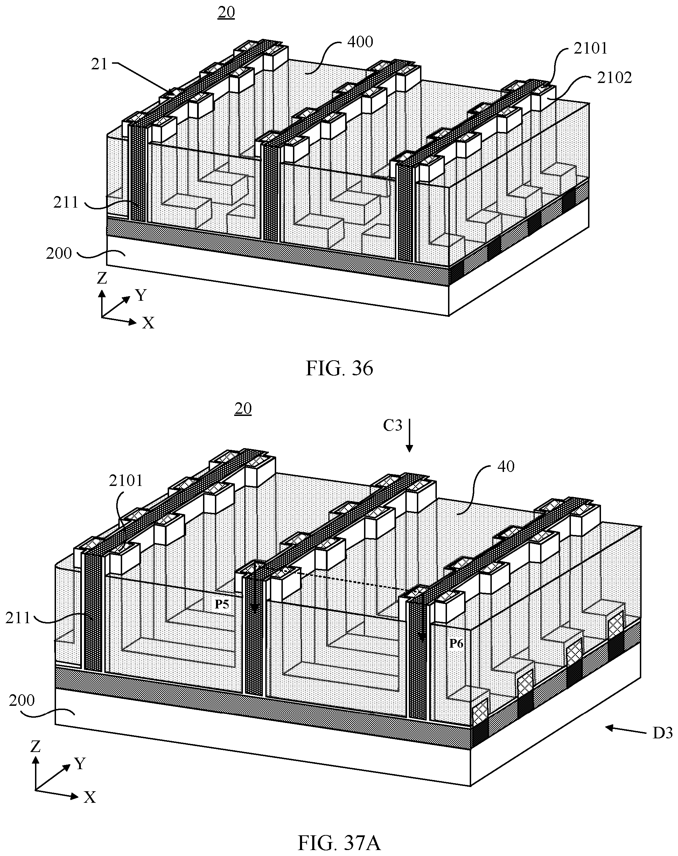

In some other embodiments of this application, as shown in FIG. 36, when the vertical channel 2101 is L-shaped, and a side that is of the second part of the vertical channel 2101 extending in the first direction X and that faces away from the first isolation barrier wall 211 is covered by the gate dielectric layer 2102, two adjacent first signal lines 2103 (as shown in FIG. 34C) that belong to different array structures 21 are connected to form the integrated conductive structural part 400 shown in FIG. 36. The integrated conductive structural part 400 is filled between two adjacent rows of L-shaped vertical channels 2101. Technical effects of the integrated conductive structural part 400 are the same as those described above, and details are not described herein again.

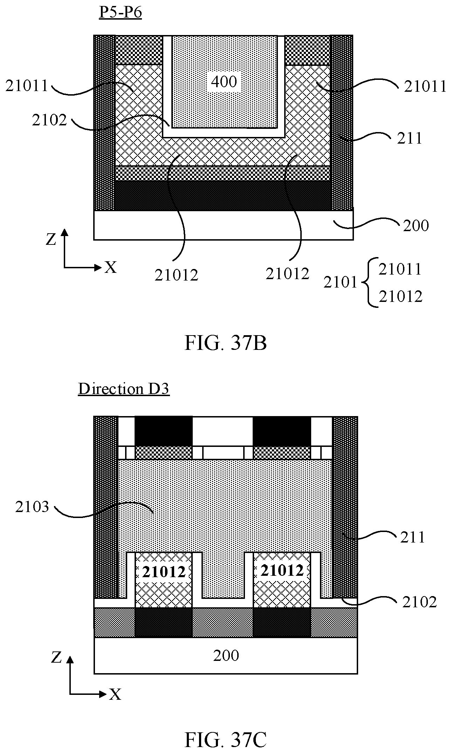

In addition, in some other embodiments of this application, as shown in FIG. 37A, a structure of the vertical channel 2101 is a U-shaped structure. As shown in FIG. 37B (a sectional view obtained by performing sectioning along a dashed line P5-P6 in FIG. 37A), second parts 21012 of two adjacent vertical channels 2101 are connected to each other, so that the two connected vertical channels 2101 form a U-shaped structure.

On this basis, after the first mask structure 53 is formed (as shown in FIG. 19A), as shown in FIG. 37A, forming, on the side wall of the first isolation barrier wall 211, the plurality of vertical channels 2101 that are spaced from each other in the second direction Y includes: removing the first mask structure 53 (as shown in FIG. 19A), forming the second mask structure 54 on the side wall of the first isolation barrier wall 211 as shown in FIG. 21A, and removing a part of the semiconductor material layer 52 and the third isolation barrier wall 213 that are exposed by the second mask structure 54, to form a plurality of U-shaped vertical channels 2101.

On this basis, two adjacent first signal lines 2103 in FIG. 37B that belong to different array structures 21 (as shown in FIG. 37A) are connected to each other to form the integrated conductive structural part 400, and the integrated conductive structural part 400 is filled between two adjacent rows of L-shaped vertical channels 2101. Technical effects of the integrated conductive structural part 400 are the same as those described above, and details are not described herein again.

In addition, as shown in FIG. 37C (a side view taken along a direction D3 in FIG. 37A), the first signal line 2103 covers a surface of the first part 21011 (as shown in FIG. 37B) that faces away from the first isolation barrier wall 211, and the first signal line 2103 further covers surfaces of the first part 21011 and the second part 21012 that are perpendicular to the first isolation barrier wall 211 and the substrate 200. Therefore, a part of the first signal line 2103 that covers the second part 21012 is similar to a horseshoe shape. Technical effects of the horseshoe-shaped first signal line 2103 are the same as that described above, and details are not described herein again.

## Claims

1. A chip, comprising:
a substrate; and
a plurality of array structures, disposed on the substrate, wherein the plurality of array structures are spaced from each other in a first direction, and each array structure comprises:
a first isolation barrier wall;
a first transistor column; and
a second transistor column, wherein the first isolation barrier wall is located between the first transistor column and the second transistor column, and both the first transistor column and the second transistor column comprise:
a plurality of vertical channels, spaced from each other on a side wall of the first isolation barrier wall in a second direction, wherein the vertical channel is vertically disposed on the substrate, the first direction intersects with the second direction, and both the first direction and the second direction are parallel to the substrate;
a gate dielectric layer, wherein the gate dielectric layer wraps the vertical channel on three sides, and the gate dielectric layer continuously covers the plurality of vertical channels, and a part of the first isolation barrier wall between the plurality of vertical channels; and
a first signal line, located on a side of the gate dielectric layer that faces away from the first isolation barrier wall, wherein the first signal line wraps the vertical channel on three sides, and the first signal line continuously covers the plurality of vertical channels, and the part of the first isolation barrier wall between the plurality of vertical channels.

2. The chip according to claim 1, wherein
the vertical channel comprises:
a first part, disposed in a direction perpendicular to the substrate; and
a second part, connected to an end of the first part that faces the substrate, wherein the second part is disposed in the first direction; and
the chip further comprises:
a second signal line, disposed between the array structure and the substrate, wherein the second signal line extends in the first direction, and the second signal line is in contact with the second part.

3. The chip according to claim 2, wherein second parts of two adjacent vertical channels in different array structures are connected to each other, so that the two vertical channels connected to each other form a U-shaped structure.

4. The chip according to claim 2 or 3, wherein
the chip comprises a plurality of second signal lines; and
the chip further comprises a third isolation barrier wall, the third isolation barrier wall is disposed between two adjacent second signal lines, and the third isolation barrier wall and the first isolation barrier wall are made of different materials.

5. The chip according to any one of claims 1 to 4, wherein
two adjacent first signal lines in different array structures are connected to each other to form an integrated conductive structural part, and the integrated conductive structural part is filled between two adjacent rows of vertical channels.

6. The chip according to claim 5, wherein the chip further comprises:
a second isolation barrier wall, wherein the second isolation barrier wall is disposed between two adjacent array structures, and is located on a side of the integrated conductive structural part that faces away from the substrate.

7. The chip according to claim 2, wherein the chip further comprises:
a second isolation barrier wall, disposed between two adjacent array structures, wherein two adjacent first signal lines in different array structures are isolated on two sides of the second isolation barrier wall, and two adjacent vertical channels in the different array structures are isolated on the two sides of the second isolation barrier wall; and
a surface of a side of the first signal line that faces away from the first isolation barrier wall is flush with a surface of a side of the second part that faces away from the first isolation barrier wall and a surface of a side of the gate dielectric layer that faces away from the first isolation barrier wall.

8. The chip according to claim 7, wherein
the first signal line covers a surface of the first part that faces away from the first isolation barrier wall, and surfaces of the first part and the second part that are perpendicular to the first isolation barrier wall and the substrate.

9. The chip according to claim 1, wherein the chip further comprises:
a second isolation barrier wall, disposed between two adjacent array structures, wherein two adjacent first signal lines in different array structures are isolated on two sides of the second isolation barrier wall; and
the first signal line covers a part of the first isolation barrier wall and has a first trench on a side facing away from the first isolation barrier wall, and a part of the second isolation barrier wall is located in the first trench.

10. The chip according to any one of claims 1 to 9, wherein the first transistor column and the second transistor column are symmetrically disposed with respect to the first isolation barrier wall.

11. The chip according to any one of claims 1 to 9, wherein each of the first transistor column and the second transistor column further comprises:
a first electrode, disposed on a side of the vertical channel that faces the substrate; and
a second electrode, disposed on a side of the vertical channel that faces away from the substrate.

12. The chip according to any one of claims 1 to 11, wherein the chip further comprises:
a capacitor array, disposed on a side of the array structure that faces away from the substrate, wherein the capacitor array is electrically connected to at least one of the first transistor column or the second transistor column to form a memory array.

13. The chip according to claim 12, wherein the chip further comprises:
a controller, wherein the controller is electrically connected to the memory array, and the controller is configured to control read/write of the memory array.

14. An electronic device, comprising:
a circuit board; and
the chip according to any one of claims 1 to 13, wherein the circuit board is electrically connected to the chip.

15. A manufacturing method for a chip, comprising:
forming, on a substrate, a plurality of first isolation barrier walls that are spaced from each other in a first direction; and
forming a transistor column on each of two side walls of the first isolation barrier wall, comprising:
forming, on the side wall, a plurality of vertical channels that are spaced from each other in a second direction, wherein the vertical channel is perpendicular to the substrate, the first direction intersects with the second direction, and both the first direction and the second direction are parallel to the substrate;
forming a gate dielectric layer on a side of the plurality of vertical channels that faces away from the isolation barrier wall, wherein the gate dielectric layer wraps the vertical channel on three sides, and the gate dielectric layer continuously covers the plurality of vertical channels, and a part of the first isolation barrier wall between the plurality of vertical channels; and
forming a first signal line on a side of the gate dielectric layer that faces away from the first isolation barrier wall, wherein the first signal line wraps the vertical channel on three sides, and the first signal line continuously covers the plurality of vertical channels, and the part of the first isolation barrier wall between the plurality of vertical channels.

16. The manufacturing method for the chip according to claim 15, wherein forming, on the substrate, the plurality of first isolation barrier walls that are spaced from each other in the first direction comprises:
forming a semiconductor material layer on the substrate;
forming, on the semiconductor material layer, a plurality of second trenches that extend in the first direction, and forming a third isolation barrier wall in the second trench, wherein the third isolation barrier wall and the first isolation barrier wall are made of different materials;
forming a first mask structure on the semiconductor material layer;
removing the semiconductor material layer and the third isolation barrier wall that are exposed by the first mask structure, to form a plurality of third trenches that are spaced from each other in the first direction; and
forming the first isolation barrier wall in the third trench.

17. The manufacturing method for the chip according to claim 16, wherein after the first mask structure is formed, forming, on the side wall, the plurality of vertical channels that are spaced from each other in the second direction comprises:
removing the first mask structure, forming a second mask structure on the side wall of the first isolation barrier wall, and removing the semiconductor material layer and the third isolation barrier wall that are exposed by the second mask structure, to form the vertical channel.

18. The manufacturing method for the chip according to claim 16, wherein after the first mask structure is formed, forming, on the side wall, the plurality of vertical channels that are spaced from each other in the second direction comprises:
removing the first mask structure, forming a second mask structure on the side wall of the first isolation barrier wall, and removing a part of the semiconductor material layer and the third isolation barrier wall that are exposed by the second mask structure, to form the plurality of U-shaped vertical channels.

19. The manufacturing method for the chip according to claim 16, wherein after the first mask structure is formed, forming, on the side wall, the plurality of vertical channels that are spaced from each other in the second direction, and forming the gate dielectric layer and the first signal line comprise:
removing the first mask structure, forming a second mask structure on the side wall of the first isolation barrier wall, and removing a part of the semiconductor material layer and the third isolation barrier wall that are exposed by the second mask structure, to form a plurality of U-shaped semiconductor structures;
sequentially forming a gate dielectric material layer and a second metal material layer in the U-shaped semiconductor structure, wherein both the gate dielectric material layer and the second metal material layer wrap the plurality of U-shaped semiconductor structures on three sides, and both the gate dielectric material layer and the second metal material layer continuously cover the U-shaped semiconductor structure, and a part of the first isolation barrier wall between the plurality of U-shaped semiconductor structures; and
removing a part of the bottom of the U-shaped semiconductor structure, and removing a part of the gate dielectric material layer and a part of the second metal material layer that cover the bottom of the U-shaped semiconductor structure, to form the L-shaped vertical channel, the gate dielectric layer, and the first signal line.
